(19)

Europäisches
Patentamt
European
Patent Office
Office européen
des brevets

(11) **EP 1 990 913 A2**

(12) **EUROPEAN PATENT APPLICATION**

(43) Date of publication:
**12.11.2008 Bulletin 2008/46**

(51) Int Cl.:
***H03G 3/30*** *(2006.01)*

(21) Application number: **08251625.3**

(22) Date of filing: **07.05.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **08.05.2007 JP 2007123498
08.05.2007 JP 2007123550
08.05.2007 JP 2007123610
12.02.2008 JP 2008030207**

(71) Applicant: **Seiko Epson Corporation
Shinjuku-ku
Tokyo 163-0811 (JP)**

(72) Inventor: **Nimura, Yoshihiko
c/o Seiko Epson Corporation
Suwa-shi,
Nagano 392-8502 (JP)**

(74) Representative: **Cloughley, Peter Andrew et al
Miller Sturt Kenyon
9 John Street
London WC1N 2ES (GB)**

(54) **Receiver circuit and amplifier circuit**

(57)    A receiver circuit includes an attenuator that receives a received signal and attenuates the received signal, a DC level shifter that shifts a DC level of an attenuated signal from the attenuator, an amplifier section that has frequency characteristics of a band-pass filter and amplifies a signal from the DC level shifter that has been shifted with respect to the DC level, and a control circuit that controls an attenuation of the attenuator based on a signal output from the amplifier section. The control circuit controls the attenuation of the attenuator by changing filter characteristics of the attenuator corresponding to an amplitude of the signal output from the amplifier section so that the signal output from the amplifier section has a constant amplitude even when an amplitude of the received signal has changed.

FIG. 1

**Description**

BACKGROUND OF THE INVENTION

The present invention relates to a receiver circuit, an amplifier circuit, and the like.

A smart entry system has been known which checks an ID code when a user carrying a smart-key portable instrument approaches a car, and unlocks the doors of the car when the user has been authenticated (JP-A-2006-37493).

In the smart entry system, an in-vehicle instrument transmits an ASK-modulated signal in an LF band. When a user carrying a portable instrument approaches a car, an antenna section of the portable instrument detects the electromagnetic field of the signal. When a receiver section of the portable instrument has received a request signal from the in-vehicle instrument, a transmitter section of the portable instrument transmits an ID code. When the ID code has been authenticated, the smart entry system unlocks the doors of the car, for example.

In the smart entry system, since the receiver section of the portable instrument must regularly detect the signal from the in-vehicle instrument, the battery of the portable instrument is consumed to a large extent, whereby battery exhaustion or the like tends to occur. Therefore, a reduction in power consumption is strongly desired for the receiver section of the portable instrument.

A receiver circuit which receives a radio signal or the like is provided with an amplifier circuit which amplifies the received signal. In order to improve the S/N ratio, it is desirable to provide a band-pass filter which selectively extracts only a frequency component of a desired signal.

In a related-art receiver circuit, a band-pass filter is provided separately from an amplifier circuit. Therefore, since two circuit elements (i.e., amplifier circuit and band-pass filter) are required for the receiver circuit, the circuit scale or power consumption increases.

When the amplitude of the received signal is small, it is desirable to cascade a plurality of amplifier circuits in order to increase the amplification factor.

In this case, when the amplification operation of each amplifier circuit is imbalanced, the amplification operating point may be shifted, whereby a stable amplification operation may not be implemented.

SUMMARY

According to one aspect of the invention, there is provided a receiver circuit comprising:

an attenuator that receives a received signal and attenuates the received signal;
a DC level shifter that shifts a DC level of an attenuated signal from the attenuator;
an amplifier section that has frequency characteristics of a band-pass filter and amplifies a signal from the DC level shifter that has been shifted with respect to the DC level; and
a control circuit that controls an attenuation of the attenuator based on a signal output from the amplifier section, the control circuit controlling the attenuation of the attenuator by changing filter characteristics of the attenuator corresponding to an amplitude of the signal output from the amplifier section so that the signal output from the amplifier section has a constant amplitude even when an amplitude of the received signal has changed.

According to another aspect of the invention, there is provided an amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and
a gain setting section that sets a gain of the amplifier circuit,
when a first bias current that flows through the first operational amplifier is referred to as IB1 and a second bias current that flows through the second operational amplifier is referred to as IB2, the amplifier circuit being provided with frequency characteristics of a band-pass filter by setting the first bias current IB1 to be larger than the second bias current IB2.

According to another aspect of the invention, there is provided an amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and

a gain setting section that sets a gain of the amplifier circuit,

the second operational amplifier being a rail-to-rail operational amplifier.

BRIEF DESCRIPTION OF THE SEVERAL VIEWS OF THE DRAWING

FIG. 1 shows a configuration example of a receiver circuit according to one embodiment of the invention.

FIG. 2 is a view illustrative of band-pass filter characteristics of an amplifier section.

FIG. 3 shows a detailed configuration example of a receiver circuit.

FIG. 4 shows a signal waveform example illustrative of the operation of a receiver circuit.

FIG. 5 shows a configuration example of a demodulator circuit.

FIG. 6 shows a signal waveform example illustrative of the operation of a demodulator circuit.

FIG. 7 shows a configuration example of an amplifier circuit according to one embodiment of the invention.

FIG. 8 is a view illustrative of band-pass filter characteristics of an amplifier circuit.

FIG. 9 is a view illustrative of a cut-off frequency of a band-pass filter.

FIG. 10 shows a configuration example of an amplifier circuit according to one embodiment of the invention.

FIG. 11 is a view illustrative of a dead zone.

FIG. 12 is a view illustrative of a shift in operating point.

FIG. 13 shows a first configuration example of a rail-to-rail operational amplifier.

FIG. 14 shows a second configuration example of a rail-to-rail operational amplifier.

FIG. 15 shows a detailed example of a second configuration example.

FIG. 16 is a view illustrative of an offset voltage setting method.

FIG. 17 shows a layout example of an amplifier circuit.

FIG. 18 shows a modification of a receiver circuit.

DETAILED DESCRIPTION OF THE EMBODIMENT

Several embodiments of the invention may provide a receiver circuit that enables a reduction in power consumption. Other embodiments of the invention may provide a receiver circuit that enables a reduction in circuit scale and power consumption. Further embodiments of the invention may provide an amplifier circuit that can implement a stable amplification operation.

According to one embodiment of the invention, there is provided a receiver circuit comprising:

an attenuator that receives a received signal and attenuates the received signal;

a DC level shifter that shifts a DC level of an attenuated signal from the attenuator;

an amplifier section that has frequency characteristics of a band-pass filter and amplifies a signal from the DC level shifter that has been shifted with respect to the DC level; and

a control circuit that controls an attenuation of the attenuator based on a signal output from the amplifier section, the control circuit controlling the attenuation of the attenuator by changing filter characteristics of the attenuator corresponding to an amplitude of the signal output from the amplifier section so that the signal output from the amplifier section has a constant amplitude even when an amplitude of the received signal has changed.

According to this embodiment, the attenuation of the received signal is controlled by the attenuator. The DC level is shifted by the DC level shifter, and the signal is amplified by the amplifier section. The control circuit controls the attenuation of the attenuator by changing the filter characteristics of the attenuator corresponding to the amplitude of the signal output from the amplifier section to maintain the amplitude of the signal output from the amplifier section at a constant level. This makes it unnecessary to provide the amplifier section with an automatic gain adjustment function, whereby the configuration of the amplifier section can be simplified while reducing power consumption. Moreover, since it suffices to control the attenuator as to only the attenuation, the configuration of the attenuator can be simplified while further reducing power consumption.

In the receiver circuit,

the attenuator may have characteristics of a high-pass filter; and

the control circuit may control the attenuation of the attenuator by changing a cut-off frequency of the high-pass filter corresponding to the amplitude of the signal output from the amplifier section.

According to this configuration, since the attenuation of the attenuator can be controlled by merely changing the cut-off frequency of the high-pass filter corresponding to the amplitude of the signal output from the amplifier section, the attenuator can be formed using simple circuit elements.

In the receiver circuit,
the control circuit may increase the attenuation of the attenuator in a frequency band of a carrier of the received signal by increasing the cut-off frequency of the high-pass filter as the amplitude of the signal output from the amplifier section increases.

According to this configuration, since the signal amplitude of the carrier which is allowed to pass through the band-pass filter of the amplifier section can be attenuated using the high-pass filter of the attenuator, an appropriate attenuation control using the attenuator can be implemented.

In the receiver circuit,
the control circuit may include a charge capacitor provided between a charge node and a first power supply, and a charge transistor provided between the charge node and a second power supply, the control circuit comparing the amplitude of the signal output from the amplifier section with a reference voltage, charging the charge capacitor using the charge transistor based on a comparison result, and outputting a voltage of the charge node to the attenuator as a control voltage.

According to this configuration, the control voltage corresponding to the amplitude of the signal output from the amplifier section can be generated at the charge node, and the attenuation of the attenuator can be controlled using the control voltage.

In the receiver circuit,
the control circuit may include a discharge transistor that is provided between the charge node and the first power supply and allows a constant current to flow toward the first power supply.

This prevents a situation in which the attenuation of the attenuator is set at a large value due to a noise signal or the like.

In the receiver circuit,
a discharge period set based on the constant current that flows through the discharge transistor and a capacitance of the charge capacitor may be longer than a transfer period of a first logic level of the received signal that is ASK-modulated.

This implements an appropriate data transfer in the data transfer period.

In the receiver circuit,
the attenuator may include:

an attenuation capacitor provided between an input node of the received signal and an output node of the attenuator; and
an attenuation transistor provided between the output node and a first power supply, a control voltage from the control circuit being input to a gate of the attenuation transistor.

According to this configuration, since the attenuation can be controlled by merely providing the attenuation capacitor and the attenuation transistor, the circuit of the attenuator can be simplified while reducing the power consumption of the attenuator.

In this embodiment, the attenuator may include a pull-down transistor provided between the output node and the first power supply.

This enables the potential of the output node to be pulled down so that noise tolerance can be improved.

In this embodiment, the amplifier section may include at least one amplifier circuit, and the amplifier circuit may include a first operational amplifier, an input signal being input to a first input terminal of the first operational amplifier; a voltage-follower-connected second operational amplifier, an output from the first operational amplifier being input to a first input terminal of the second operational amplifier, and an output from the second operational amplifier being input to a second input terminal of the second operational amplifier and a second input terminal of the first operational amplifier; and a gain setting section that sets a gain of the amplifier circuit.

According to this configuration, band-pass filter characteristics can be implemented in which the gain at the center frequency is set by the gain setting section, and the DC level is cut by feedback of the second operational amplifier, for example.

According to another embodiment of the invention, there is provided an amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and
a gain setting section that sets a gain of the amplifier circuit,

when a first bias current that flows through the first operational amplifier is referred to as IB1 and a second bias current that flows through the second operational amplifier is referred to as IB2, the amplifier circuit being provided with frequency characteristics of a band-pass filter by setting the first bias current IB 1 to be larger than the second bias current IB2.

According to this embodiment, the output from the first operational amplifier is fed back to the second input terminal of the first operational amplifier through the voltage-follower-connected second operational amplifier. The first and second bias currents IB1 and IB2 of the first and second operational amplifiers satisfy the relationship IB1>IB2. Therefore, the first operational amplifier is set to be a high-speed operational amplifier, and the second operational amplifier is set to be a low-speed operational amplifier. This enables the amplifier circuit to be provided with band-pass filter characteristics in which the low-frequency-side attenuation characteristics are set based on the characteristics of the second operational amplifier and the high-frequency-side attenuation characteristics are set based on the characteristics of the first operational amplifier. This enables the amplifier circuit to be provided with a band-pass filter function and an amplification function, whereby the circuit scale and power consumption can be reduced.

In the amplifier circuit,
a low-frequency-side cut-off frequency of the band-pass filter may be set based on an output impedance of the second operational amplifier and a load capacitance of an output node of the second operational amplifier, and a high-frequency-side cut-off frequency of the band-pass filter may be set based on an output impedance of the first operational amplifier and a load capacitance of an output node of the first operational amplifier.

According to this configuration, the low-frequency-side cut-off frequency of the band-pass filter can set by adjusting the output impedance and the load capacitance of the second operational amplifier, and the high-frequency-side cut-off frequency of the band-pass filter can set by adjusting the output impedance and the load capacitance of the first operational amplifier.

In the amplifier circuit,
the gain setting section may include:

a first capacitor provided between an output of the first operational amplifier and the second input terminal of the first operational amplifier; and
a second capacitor provided between an output of the second operational amplifier and a first power supply.

According to this configuration, the gain of the amplifier circuit at the center frequency of the band-pass filter can be set by adjusting the capacitance ratio of the first and second capacitors, for example.

In the amplifier circuit,
when an offset voltage of the first operational amplifier is referred to as VOF1 and an offset voltage of the second operational amplifier is referred to as VOF2, the offset voltage VOF1 may be set to be higher than the offset voltage VOF2.

This enables the offset voltage of the amplifier circuit to be minimized, whereby a shift in the operating point can be prevented while reducing power consumption.

In the amplifier circuit,
when a gate length and a gate width of differential-pair transistors of the first operational amplifier are respectively referred to as L1 and W1 and a gate length and a gate width of differential-pair transistors of the second operational amplifier are respectively referred to as L2 and W2, $L1 \times W1$ may be set to be smaller than $L2 \times W2$.

According to this configuration, the offset voltage VOF1 can be set to be higher than the offset voltage VOF2 (VOF1>VOF2) by adjusting the gate length and the gate width of the differential-pair transistors.

According to another embodiment of the invention, there is provided an amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and
a gain setting section that sets a gain of the amplifier circuit,
the second operational amplifier being a rail-to-rail operational amplifier.

According to this embodiment, the output from the first operational amplifier is fed back to the second input terminal of the first operational amplifier through the voltage-follower-connected second operational amplifier. The second operational amplifier is formed using a rail-to-rail operational amplifier. Therefore, the signal can be amplified using the second operational amplifier in a well-balanced manner with respect to the small-signal-amplitude operating point. As a result, imbalance relating to signal feedback from the output of the first operational amplifier to the inverting input terminal of the first operational amplifier can be reduced, whereby a situation in which the operating point is shifted can be prevented.

In the amplifier circuit,
the second operational amplifier may include:

a first differential section that includes a first current-mirror circuit, first differential-pair transistors, and a first current source transistor;
a second differential section that includes a second current-mirror circuit, second differential-pair transistors, and a second current source transistor;
an output section, an output from the first differential section being input to the output section;
a first transistor provided between a first node and a first power supply, the first node being a drain node of one transistor of the first differential-pair transistors of the first differential section, and a third node being connected to a gate of the first transistor, the third node being a drain node of one transistor of the second differential-pair transistors of the second differential section; and
a second transistor provided between a second node and the first power supply, the second node being a drain node of the other transistor of the first differential-pair transistors, and a fourth node being connected to a gate of the second transistor, the fourth node being a drain node of the other transistor of the second differential-pair transistors;
a gate of the one transistor of the first differential-pair transistors may be connected to a gate of the other transistor of the second differential-pair transistors; and
a gate of the other transistor of the first differential-pair transistors may be connected to a gate of the one transistor of the second differential-pair transistors.

According to this configuration, the signal can be amplified using the first differential section or the second differential section even if the voltage of the signal input to the second operational amplifier has increased or decreased, whereby a situation in which a dead zone is formed on the upper side or the lower side of the power supply voltage range can be prevented. Therefore, the signal can be amplified in a well-balanced manner with respect to the operating point.

In the amplifier circuit,
the first operational amplifier may include a differential section;
the second operational amplifier may include a first differential section and a second differential section;
an output of the differential section of the first operational amplifier may be connected to first input terminals of the first differential section and the second differential section of the second operational amplifier; and
an output of the first differential section may be connected to an output of the second differential section, and the output of the first differential section and the output of the second differential section may be connected to a second input terminal of the first differential section and a second input terminal of the second differential section.

According to this configuration, since the first operational amplifier can be formed using the differential section and the second operational amplifier can be formed using the first differential section and the second differential section, the circuit size can be reduced while reducing power consumption. Moreover, since the signal can be amplified using the first differential section and the second differential section in a well-balanced manner with respect to the small-signal-amplitude operating point, imbalance relating to signal feedback from the output of the first operational amplifier to the inverting input terminal of the first operational amplifier can be reduced.

In the amplifier circuit,
the differential section of the first operational amplifier may include:

a current-mirror circuit;
differential-pair transistors, the input signal being input to a gate of one transistor of the differential-pair transistors, and the output of the first differential section and the output of the second differential section being connected to a gate of the other transistor of the differential-pair transistors; and
a current source transistor that supplies a bias current that flows through the current-mirror circuit and the differential-pair transistors;
the first differential section of the second operational amplifier may include:

a first current-mirror circuit is configured by P-type transistors;
first differential-pair transistors, an output of the differential section being connected to a gate of one N-type transistor of the first differential-pair transistors, and the output of the first differential section and the output of the second differential section being connected to a gate of the other N-type transistor of the first differential-pair transistors; and

a first current source transistor that supplies a bias current that flows through the first current-mirror circuit and the first differential-pair transistors and is configured by an N-type transistor; and
the second differential section of the second operational amplifier may include:
a second current-mirror circuit that is configured by N-type transistors;
second differential-pair transistors, the output of the differential section being connected to a gate of one P-type transistor of the second differential-pair transistors, and the output of the first differential section and the output of the second differential section being connected to a gate of the other P-type transistor of the second differential-pair transistors; and
a second current source transistor that supplies a bias current that flows through the second current-mirror circuit and the second differential-pair transistors and is configured by a P-type transistor.

According to this configuration, a rail-to-rail operational amplifier using the first differential section and the second differential section can be implemented by a simple circuit configuration, and power consumption can be easily reduced.

In the amplifier circuit,
the differential-pair transistors of the differential section, the first differential-pair transistors of the first differential section, and the second current-mirror circuit of the second differential section may be disposed along a first direction; and
when a direction perpendicular to the first direction is referred to as a second direction, the second differential-pair transistors of the second differential section may be disposed in the second direction with respect to the second current-mirror circuit.

The differential section, the first differential section, and the second differential section can be compactly disposed along the first direction by disposing the transistors in this manner.

In the amplifier circuit,
an output line of the differential section may be provided along the first direction from the differential-pair transistors toward the second current-mirror circuit, and may be provided along the second direction from the second current-mirror circuit toward the second differential-pair transistors.

According to this configuration, the output line of the differential section can be efficiently disposed along the first direction and the second direction.

In the amplifier circuit,
the gain setting section may include:

a first capacitor provided between the output of the first operational amplifier and the second input terminal of the first operational amplifier; and
a second capacitor provided between the output of the second operational amplifier and a first power supply;
when a direction opposite to the first direction is referred to as a third direction and a direction opposite to the second direction is referred to as a fourth direction, the output line of the differential section may be provided along the third direction from the second differential-pair transistors toward the first capacitor and connected to one end of the first capacitor; and
a connection line from the other end of the first capacitor may be provided along the fourth direction from the first capacitor toward the differential-pair transistors of the differential section.

This enables the output line to be disposed efficiently, whereby the parasitic capacitance of the output line can be reduced. Therefore, the operation speed of the first operational amplifier can be increased.

In the amplifier circuit,
when a direction opposite to the second direction is referred to as a fourth direction, the current source transistor of the differential section may be disposed in the fourth direction with respect to the differential-pair transistors, and the first current source transistor of the first differential section may be disposed in the fourth direction with respect to the first differential-pair transistors.

According to this configuration, since the current source transistor of the differential section and the first current source transistor of the first differential section can be disposed effectively utilizing the space in the fourth direction with respect to the differential-pair transistors, a compact layout can be implemented.

Preferred embodiments of the invention are described in detail below. Note that the embodiments described below do not in any way limit the scope of the invention defined by the claims laid out herein. Note that all elements of the embodiments described below should not necessarily be taken as essential requirements for the invention.

1. Receiver circuit

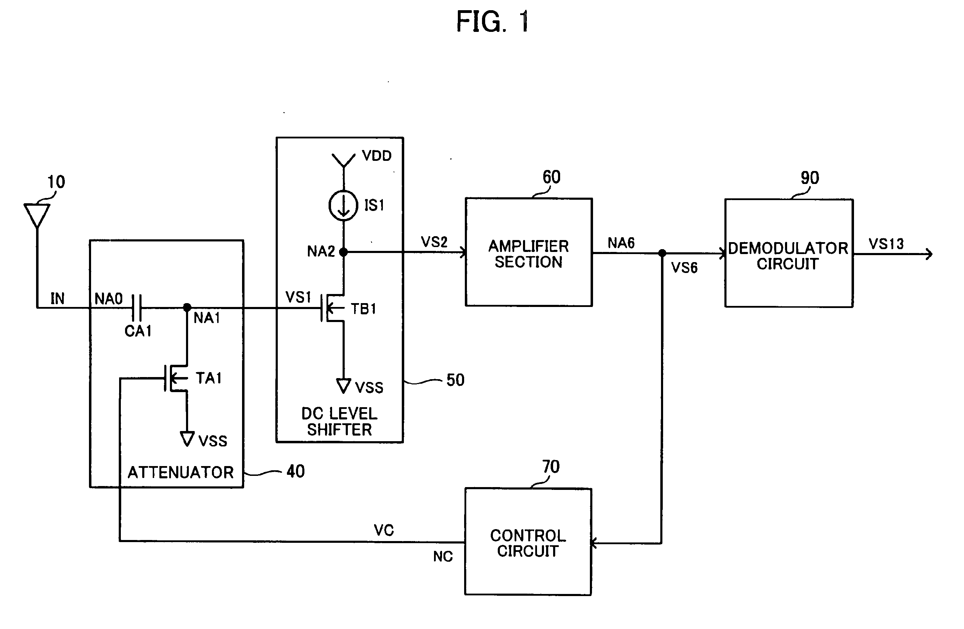

FIG. 1 shows a configuration example of a receiver circuit according to one embodiment of the invention. The receiver circuit according to this embodiment is not limited to the configuration shown in FIG. 1. Various modifications may be made such as omitting some of the elements or adding other elements.

The receiver circuit shown in FIG. 1 includes an attenuator 40, a DC level shifter 50, an amplifier section 60, and a control circuit 70. The receiver circuit may include a demodulator circuit 90.

A received signal IN from an antenna section 10 formed using a coil (LC resonant circuit) or the like is input to the attenuator 40. The attenuator 40 (filter circuit) attenuates the received signal IN. In the case of a smart entry system, for example, the received signal IN in a low frequency (LF) band subjected to amplitude shift keying (ASK) modulation (i.e., the amplitude of a carrier is changed corresponding to an input digital signal) is input to the attenuator 40. The attenuator 40 attenuates the amplitude of the ASK-modulated (amplitude-modulated) received signal IN in the LF band (e.g., 120 to 140 KHz) based on a control voltage VC (control signal) from the control circuit 70.

The attenuator 40 includes an attenuation capacitor CA1 provided between a received signal IN input node NA0 and an output node NA1 of the attenuator 40, and an N-type attenuation transistor TA1 which is provided between the output node NA1 and a power supply VSS (first power supply in a broad sense) and to which the control voltage VC from the control circuit 70 is input at its gate. The attenuator 40 has frequency characteristics of a high-pass filter (hereinafter may be referred to as "high-pass filter frequency characteristics"), for example. Specifically, a high-pass filter is formed utilizing the capacitance of the capacitor CA1 and the on-resistance of the transistor TA1. Note that the attenuator 40 may have characteristics of a low-pass filter, and the attenuation of the attenuator 40 may be controlled by controlling the cut-off frequency of the low-pass filter.

The DC level shifter 50 shifts the DC level of an attenuated signal VS1, and outputs a signal VS2 which has been shifted with respect to the DC level. Specifically, the DC level shifter 50 performs level shift conversion so that the DC level of the signal VS2 is set at the small-signal amplification operating point (amplification center level) of the amplifier section 60. The DC level shifter 50 includes an N-type transistor TB1 which is provided between the power supply VSS (first power supply) and an output node NA2 and to which the signal VS1 from the attenuator 40 is input at its gate, and a current source IS1 provided between a power supply VDD (second power supply) and the output node NA2.

The amplifier section 60 amplifies the signal VS2 which has been shifted with respect to the DC level, and outputs an amplified signal VS6. The amplifier section 60 has frequency characteristics of a band-pass filter (hereinafter may be referred to as "band-pass filter frequency characteristics"), for example. Specifically, the amplifier section 60 has band-pass filter frequency characteristics of which the center frequency corresponds to the frequency band (e.g., 120 to 140 KHz) of the carrier (desired signal) of the received signal IN.

The demodulator circuit 90 performs a demodulation process based on the signal VS6 from the amplifier section 60. Specifically, the demodulator circuit 90 performs the demodulation process in order to obtain an input digital signal from the ASK-modulated signal.

The control circuit 70 changes the attenuation of the attenuator 40 corresponding to the amplitude of the signal VS6 output from the amplifier section 60. For example, the control circuit 70 performs an automatic gain adjustment which detects the amplitude of the signal VS6 and changes the attenuation of the attenuator 40 based on the amplitude detection result.

Specifically, the control circuit 70 controls the attenuation of the attenuator 40 by changing the filter characteristics (cutoff frequency) of the attenuator 40 so that the signal VS6 output from the amplifier section 60 has a constant (including almost constant) amplitude even if the amplitude of the received signal IN has changed. For example, when the attenuator 40 has high-pass filter characteristics, the control circuit 70 controls the attenuation of the attenuator 40 by changing the cut-off frequency of the high-pass filter based on the amplitude (amplitude detection result) of the signal VS6. For example, the control circuit 70 increases the attenuation of the attenuator 40 in the frequency band of the carrier of the received signal by increasing the cut-off frequency of the high-pass filter as the amplitude of the signal VS6 output from the amplifier section 60 increases.

In a smart entry system, since a signal from an in-vehicle instrument is transmitted to a smart-key portable instrument (electronic instrument) via wireless communication, the amplitude of the received signal changes to a large extent (e.g., 1 mV to several hundreds of mV) depending on the distance between the in-vehicle instrument and the portable instrument. Therefore, it is necessary to automatically adjust the gain so that the signal VS6 output from the amplifier section 60 has a constant amplitude even if the amplitude of the received signal has changed. Such an automatic gain adjustment causes the signal VS6 having a constant amplitude to be input to the demodulator circuit 90, whereby the demodulation process of the demodulator circuit 90 is facilitated.

As a comparative example method, the amplitude of the signal VS6 may be made constant by adjusting the gain (amplification factor) of the amplifier section 60.

According to the comparative example method, since the amplifier section 60 must be provided with an automatic gain adjustment function, the circuit configuration of the amplifier section 60 becomes complicated. Moreover, a bias current that flows through an operational amplifier of the amplifier section 60 increases, thereby making it difficult to reduce power consumption. In particular, since a portable instrument involved in a smart entry system must regularly receive a signal transmitted from an in-vehicle instrument, an increase in current consumption of the amplifier section 60 cannot be disregarded.

According to this embodiment, an automatic gain adjustment is implemented by adjusting the attenuation of the attenuator 40. Therefore, since the amplifier section 60 need not be provided with an automatic gain adjustment function, the design of an operational amplifier of the amplifier section 60 can be simplified. Therefore, a bias current that flows through the operational amplifier of the amplifier section 60 can be easily reduced, whereby the power consumption of the receiver circuit can be reduced to a large extent. This makes it possible to provide a receiver circuit optimum for a smart entry system and the like.

In FIG. 1, the attenuation of the attenuator 40 becomes a minimum when the amplitude of the received signal IN is a minimum (e.g., 1 mV). The operational amplifier of the amplifier section 60 is optimally designed so that a signal having the minimum amplitude can be appropriately amplified while minimizing current consumption. The attenuation of the attenuator 40 increases as the amplitude of the received signal IN increases. The attenuation of the attenuator 40 becomes a maximum when the amplitude of the received signal IN is a maximum (e.g., several hundreds of mV). Therefore, since a signal having an amplitude almost equal to the minimum amplitude is input to the amplifier section 60 even when the amplitude of the received signal IN is a maximum, the signal can be amplified using an operational amplifier optimally designed for a signal having the minimum amplitude.

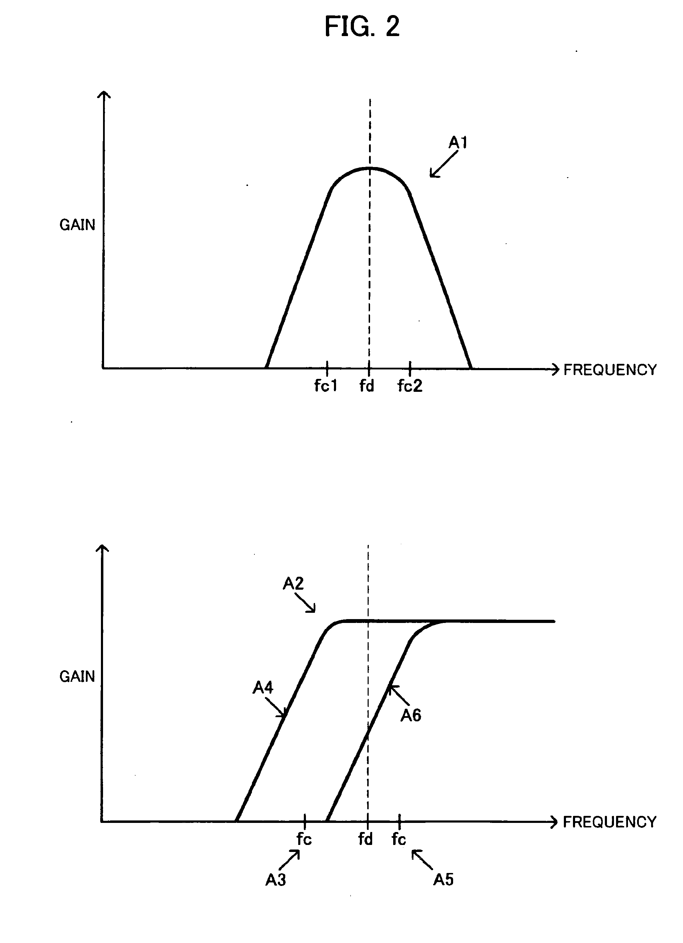

According to this embodiment, the amplifier section 60 has band-pass filter characteristics indicated by A1 in FIG. 2. Specifically, the amplifier section 60 has band-pass filter characteristics in which the frequency fd of the carrier is set to be the center frequency, the low-frequency-side cut-off frequency is set at fc1, and the high-frequency-side cut-off frequency is set at fc2.

The amplifier section 60 having such band-pass filter characteristics allows the frequency component of the carrier (desired signal) to pass through while removing the frequency component of unnecessary signals. Therefore, since unnecessary signals such as a noise signal can be removed utilizing the band-pass filter characteristics of the amplifier section 60, the S/N ratio can be improved so that a stable operation of the demodulator circuit 90 in the subsequent stage can be implemented, for example. Moreover, since the DC component can be cut off, a DC-offset-free configuration can be easily implemented.

On the other hand, the attenuator 40 has high-pass filter characteristics indicated by A2 in FIG. 2. The control circuit 70 controls the attenuation of the attenuator 40 by changing the cut-off frequency fc of the high-pass filter based on the amplitude detection result.

Specifically, when the amplitude of the received signal IN is small, the cut-off frequency fc of the attenuator 40 is set at a frequency indicated by A3 in FIG. 2, and the high-pass filter has characteristics indicated by A4, for example.

Specifically, when the capacitance of the capacitor CA1 of the attenuator 40 is referred to as CA and the on-resistance of the transistor TA1 is referred to as RA, the cut-off frequency fc of the attenuator 40 is expressed by $fc=1/(2\pi \times CA \times RA)$. Since the control voltage VC from the control circuit 70 decreases (e.g., VC=0 V) when the amplitude of the received signal IN is small, the on-resistance RA of the transistor TA1 to which the control voltage VC is input at its gate increases. Therefore, the cut-off frequency fc ($=1/(2\pi \times CA \times RA)$) decreases (fc<fd), as indicated by A3 in FIG. 2. Since the gain of the high-pass filter at the frequency fd of the carrier is set at one when the cut-off frequency fc is lower than the frequency fd, for example, the attenuation of the attenuator 40 decreases (decreases to approximately zero).

When the amplitude of the received signal IN has increased, the cut-off frequency fc of the attenuator 40 is set at a frequency indicated by A5 in FIG. 2, and the high-pass filter has characteristics indicated by A6. Specifically, the control voltage VC from the control circuit 70 increases (e.g., VC=VDD) when the amplitude of the received signal IN increases, whereby the on-resistance RA of the transistor TA1 decreases. Therefore, the cut-off frequency fc ($=1/(2\pi \times CA \times RA)$) increases (fc>fd), as indicated by A5 in FIG. 2. Since the gain of the high-pass filter at the frequency fd becomes smaller than one when the cut-off frequency fc is higher than the frequency fd, the attenuation of the attenuator 40 increases. Therefore, a signal having an almost constant amplitude is input to the amplifier section 60 even if the amplitude of the received signal IN has changed.

In FIG. 1, since the attenuator 40 is formed using the capacitor CA1 and the transistor TA1, an increase in circuit scale can be minimized. Moreover, since an operational amplifier or the like is not used to adjust the attenuation of the attenuator 40, an increase in power consumption can also be minimized. This reduces the power consumption of the receiver circuit to a large extent in combination with a reduction in power consumption of the amplifier section 60.

2. Detailed configuration example

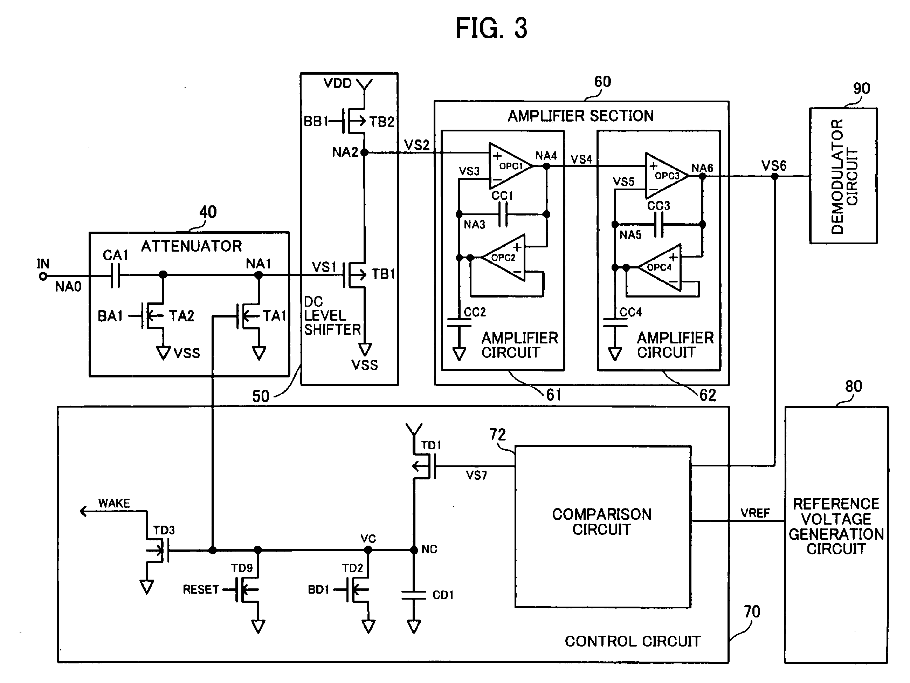

FIG. 3 shows a detailed configuration example of the receiver circuit. Note that FIG. 3 shows only one example of the configuration of the receiver circuit. The receiver circuit according to the invention is not limited to the configuration shown in FIG. 3. For example, the attenuator 40, the DC level shifter 50, the amplifier section 60, and the control circuit 70 may have configurations differing from those shown in FIG. 3.

The attenuator 40 includes a pull-down transistor TA2 in addition to the capacitor CA1 and the transistor TA1. The pull-down transistor TA2 is provided between the output node NA1 of the attenuator 40 and the power supply VSS (first power supply), and pulls down the output node NA1. Specifically, a bias voltage BA1 is input to the gate of the N-type pull-down transistor TA2 so that a constant current flows toward the power supply VSS. The pull-down transistor TA2 has a current supply capability lower than that of the attenuation transistor TA1. For example, the pull-down transistor TA2 has a gate width/gate length (W/L) ratio about 1/1 0th to 1/50th of that of the attenuation transistor TA1.

The node NA1 can be pulled down to 0 V (VSS) by providing the pull-down transistor TA2 when the received signal IN is not input due to a long distance between an in-vehicle instrument and a portable instrument, for example. Specifically, since the DC-cut capacitor CA1 is provided in the attenuator 40, the node NA1 is set in a floating state when the received signal IN is not input to the attenuator 40. Therefore, the potential of the node NA becomes unstable when the pull-down transistor TA2 is not provided, whereby noise tolerance may deteriorate.

In FIG. 3, since the pull-down transistor TA2 is provided, the potential of the node NA1 is pulled down and stabilized even when the received signal IN is not input to the attenuator 40 and the control voltage VC is set at 0 V, for example. Therefore, noise tolerance can be improved.

The DC level shifter 50 includes an N-type transistor TB1 to which the signal VS1 is input at its gate, and a P-type transistor TB2 to which a bias voltage BB1 is input at its gate. The transistor TB2 functions as the current source IS1 shown in FIG. 1. A resistor or the like which functions as a current source may be provided instead of the transistor TB2.

The amplifier section 60 includes a plurality of cascaded amplifier circuits 61 and 62. Specifically, the amplifier circuit 61 amplifies the signal VS2 output from the DC level shifter 50, and outputs an amplified signal VS4 to the amplifier circuit 62. The amplifier circuit 62 amplifies the signal VS4 output from the amplifier circuit 61, and outputs the amplified signal VS6 to the demodulator circuit 90 and the control circuit 70. Note that only one amplifier circuit may be provided in the amplifier section 60, or three or more cascaded amplifier circuits may be provided in the amplifier section 60.

The amplifier circuit 61 includes a first operational amplifier OPC1 and a second operational amplifier OPC2. The amplifier circuit 61 also includes capacitors CC1 and CC2 that function as a gain setting section for setting the gain of the amplifier circuit 61.

The signal VS2 input from the DC level shifter 50 is input to a non-inverting input terminal (first input terminal in a broad sense) of the operational amplifier OPC 1. The output from the operational amplifier OPC1 is input to a non-inverting input terminal (first input terminal) of the operational amplifier OPC2. The output from the operational amplifier OPC2 is input to an inverting input terminal (second input terminal in a broad sense) of the operational amplifier OPC2 and an inverting input terminal (second input terminal) of the operational amplifier OPC1. Specifically, the operational amplifier OPC2 is a voltage-follower-connected operational amplifier. The configuration of the amplifier circuit 62 is similar to that of the amplifier circuit 61. Therefore, description of the configuration of the amplifier circuit 62 is omitted. A modification may be made in which the operational amplifier OPC2 is provided with a gain adjustment function.

A reference voltage generation circuit 80 generates and outputs a reference voltage VREF.

The control circuit 70 includes a charge capacitor CD1 provided between a charge node NC and the power supply VSS (first power supply), and a charge transistor TD1 provided between the charge node NC and the power supply VDD (second power supply in a broad sense). A comparison circuit 72 (charge control circuit) included in the control circuit 70 compares the signal VS6 output from the amplifier section 60 with the reference voltage VREF, and controls charging of the charge capacitor CD1 using the charge transistor TD1 based on the comparison result. The voltage of the charge node NC is output to the attenuator 40 as the control voltage VC.

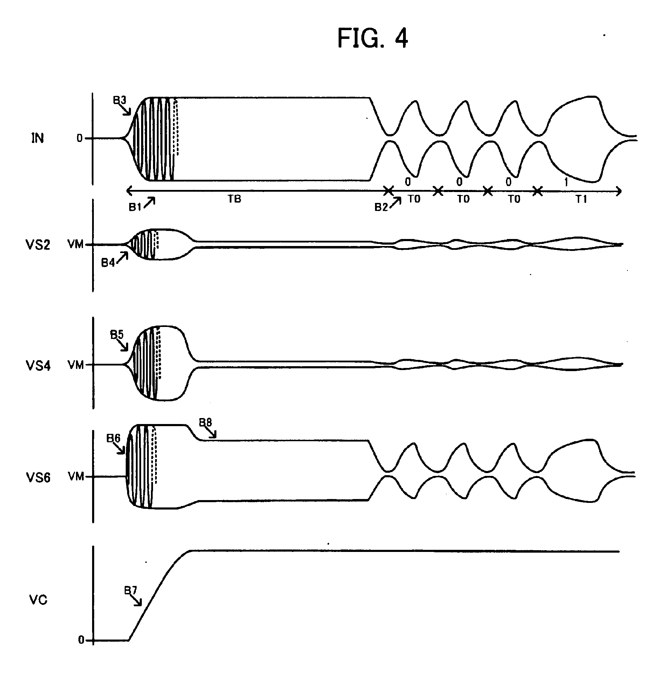

FIG. 4 shows a signal waveform example illustrative of the operation of the receiver circuit. In a burst period TB indicated by B1 in FIG. 4, the receiver circuit receives a burst signal having a given number of pulses from an in-vehicle instrument as the received signal IN. The burst period TB corresponds to a preamble period. In the burst period TB, the receiver circuit receives a burst signal which is not ASK-modulated. The receiver circuit performs an automatic gain adjustment on the received signal IN in the burst period TB.

As indicated by B2 in FIG. 4, an ASK-modulated signal corresponding to logic levels 0 and 1 of a digital signal is transmitted in transfer periods T0 and T1 subsequent to the burst period TB. The transfer periods T0 and T1 differ in duration (e.g., T0<T1). Whether a digital signal at a logic level 0 or 1 has been transmitted from the in-vehicle instrument can be detected by detecting the duration of the transfer period. Although FIG. 4 shows an example in which the transfer period T0 may be shorter than the transfer period T1, the transfer period T0 may be longer than the transfer period T1.

The received signal IN is a signal around 0 V, as indicated by B3 in FIG. 4. As indicated by B4, the DC level shifter 50 shifts the DC level of the received signal IN to the voltage level (VM) of the small-signal amplification operating point (amplification center level) of the amplifier section 60. As indicated by B5, the amplifier circuit 61 of the amplifier section 60 amplifies the signal VS2 that has been shifted with respect to the DC level, and outputs the amplified signal VS4. As indicated by B6, the amplifier circuit 62 amplifies the signal VS4, and outputs the amplified signal VS6.

When the amplitude of the signal VS6 output from the amplifier section 60 is larger than that of the reference voltage VREF from the reference voltage generation circuit 80, a signal output from a comparator included in the comparison circuit 72 changes so that a signal VS7 is set at the L level. Specifically, the signal VS7 is set at the L level each time the amplitude of the pulse output of the signal VS6 exceeds the reference voltage VREF, whereby the P-type transistor TD1 is turned ON. This causes the charge capacitor CD1 to be charged through the charge transistor TD1 so that the control voltage VC increases, as indicated by B7 in FIG. 4. Therefore, the on-resistance of the attenuation transistor TA1 decreases.

For example, when the capacitance of the attenuation capacitor CA1 is referred to as CA and the on-resistance of the transistor TA1 is referred to as RA, the transfer function of the attenuator 40 is expressed by the following equation.

$$S=VS1/IN=j\omega\times CA\times RA/(1+j\omega\times CA\times RA) \qquad (1)$$

Therefore, the cut-off frequency fc of the attenuator 40 (high-pass filter) is expressed by the following equation.

$$fc=1/(2\pi\times CA\times RA) \qquad (2)$$

The on-resistance RA of the transistor TA1 is expressed by the following equation,

$$RA=1/\{\mu\times Cox\times(W/L)\times Vgs\} \qquad (3)$$

where, $\mu$ indicates the mobility of the transistor, Cox indicates the gate capacitance, W and L respectively indicate the gate width and the gate length of the transistor, and Vgs indicates the gate-source voltage.

As is clear from the equation (3), the gate-source voltage Vgs increases as the control voltage VC increases, whereby the on-resistance RA decreases. As is clear from the equation (2), the cut-off frequency fc of the high-pass filter increases, as indicated by A5 and A6 in FIG. 2, as the on-resistance RA decreases. Therefore, the attenuation of the attenuator 40 increases so that the automatic gain adjustment of the attenuator 40 is implemented.

When the automatic gain adjustment has been implemented, the amplitude of the signal VS6 output from the amplifier section 60 becomes almost constant in the burst period TB, as indicated by B8 in FIG. 4. Therefore, the demodulator circuit 90 which has received the signal VS6 having a constant amplitude can stably demodulate the ASK-modulated signal in the periods T0 and T1 subsequent to the burst period TB.

The control circuit 70 includes a discharge transistor TD2 which is provided between the charge node NC and the power supply VSS (first power supply) and through which a constant current flows toward the power supply VSS. The discharge transistor TD2 has a current supply capability lower than that of the charge transistor TD1, for example. For example, the discharge transistor TD2 has a W/L (gate width/gate length) ratio smaller than that of the charge transistor TD1.

Specifically, the discharge period set based on a constant current that flows through the discharge transistor TD2 and the capacitance of the charge capacitor CD1 is longer than the transfer period T1 of the logic level 1 (first logic level in a broad sense) of the received signal which is ASK-modulated. Specifically, the bias voltage BD1 is input to the gate of the discharge transistor TD2 so that a constant current flows through the discharge transistor TD2. The discharge period of the discharge transistor TD2 is set based on the amount of the constant current and the capacitance of the charge capacitor CD1. The constant current that flows through the discharge transistor TD2 is set so that the discharge period is sufficiently longer than (e.g., 10 times or more) the transfer period T1 of the logic level 1. Specifically, the bias voltage BD1 and the W/L ratio of the discharge transistor TD2 are set so that the above condition is satisfied.

Since the amplitude of the received signal IN decreases as the distance between the in-vehicle instrument and the portable instrument increases, the circuit constants of the receiver circuit according to this embodiment are set so that the received signal IN having a very small amplitude can be detected. Therefore, a noise signal may be detected as the received signal IN, whereby the control voltage VC may increase. When the control voltage VC has increased due to the noise signal and the on-resistance of the attenuation transistor TA1 has decreased, the attenuation of the attenuator 40 is set at a large value before the desired received signal IN is input. In this case, the attenuation of the attenuator 40 may not return to the original value, whereby appropriate attenuation control may not be implemented.

In FIG. 3, a small amount of constant current always flows toward the power supply VSS through the discharge transistor TD2. Therefore, even if the potential of the control voltage VC has increased due to the noise signal, the potential of the control voltage VC is returned to the potential of the power supply VSS through the discharge transistor TD2. As a result, a situation can be prevented in which the on-resistance of the attenuation transistor TA1 decreases due to the noise signal so that the attenuation of the attenuator 40 is set at a large value before the desired received signal IN is input.

The discharge period of the discharge transistor TD2 is set to be sufficiently longer than the transfer period T1 of the logic level 1 which is longer than the transfer period T0. Therefore, the discharge operation through the discharge transistor TD2 can be practically disregarded in the original data transfer period. As a result, an appropriate data transfer can be implemented.

In FIG. 3, an N-type wakeup transistor TD3 is also provided. The control voltage VC is input to the gate of the transistor TD3. The source of the transistor TD3 is connected to the power supply VSS. A wakeup signal WAKE is output from the drain of the transistor TD3. Therefore, when the control voltage VC has exceeded the threshold voltage of the transistor TD3, for example, the wakeup signal WAKE becomes active (i.e., changes from the H level to the L level). This enables the receiver circuit and other circuits of an integrated circuit device including the receiver circuit to be notified that the burst signal has been detected in the burst period TB and the circuits must start operation (wakeup).

In FIG. 3, an N-type reset transistor TD9 is also provided. A reset signal is input to the gate of the transistor TD9, and the source of the transistor TD9 is connected to the power supply VSS. When the reset signal is set at the H level (active), the transistor TD9 resets the charge node NC to the VSS level.

3. Demodulator circuit

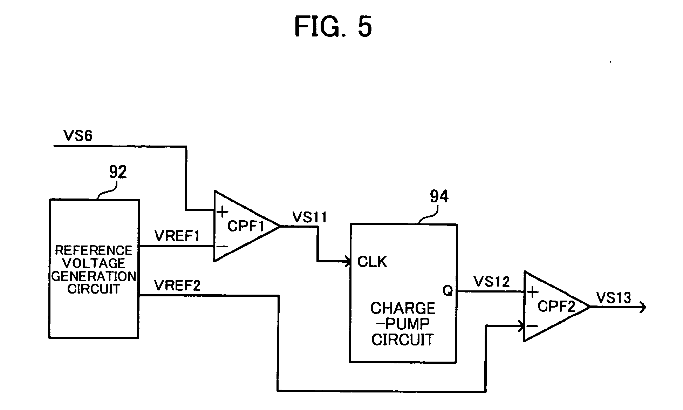

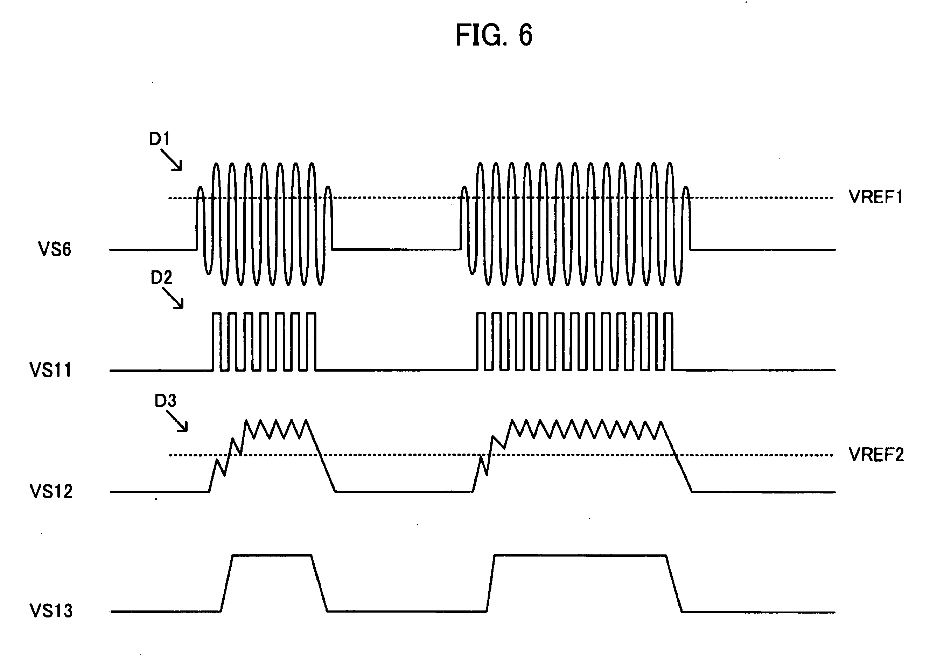

FIG. 5 shows a configuration example of the demodulator circuit 90. FIG. 6 shows a signal waveform example illustrative of the operation of the demodulator circuit 90. The demodulator circuit 90 includes a reference voltage generation circuit 92, comparators CPF1 and CPF2 (comparison circuits), and a charge-pump circuit 94 (SCF circuit).

When the signal VS6 output from the amplifier section 60 is input to the demodulator circuit 90, as indicated by D1 in FIG. 6, the comparator CPF1 compares the voltage level of the signal VS6 with a first reference voltage VREF1 from the reference voltage generation circuit 92. The comparator CPF1 outputs a binary clock signal VS11, as indicated by D2. The clock signal VS11 is input to the charge-pump circuit 94. The charge-pump circuit 94 performs a charge-pump operation using a pumping capacitor and a backup capacitor (not shown) based on the clock signal VS11. This increases the voltage level of a signal VS12, as indicated by D3 in FIG. 6. The comparator OPF2 compares the voltage level of the signal VS12 with a second reference voltage VREF2 from the reference voltage generation circuit 92. The comparator OPF2 outputs a demodulated signal VS13 which is set at the H level (active) when the voltage level of the signal VS12 exceeds the second reference voltage VREF2. The signal from the in-vehicle instrument is thus demodulated.

Note that FIG. 5 shows only one example of the demodulator circuit 90. The demodulator circuit 90 according to the invention is not limited to the configuration shown in FIG. 5. Various modifications may be made such as detecting the envelope of the signal VS6.

4. Amplifier circuit

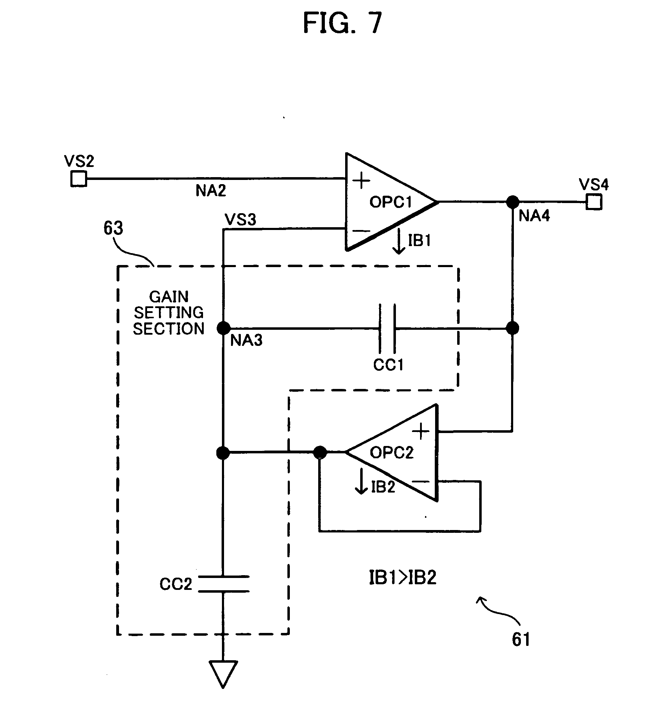

FIG. 7 shows a configuration example of the amplifier circuit 61 according to this embodiment. Note that the amplifier circuit 61 according to this embodiment is not limited to the configuration shown in FIG. 7. Various modifications may be made such as omitting some of the elements or adding other elements. The amplifier circuit according to this embodiment may also be applied to a circuit other than the receiver circuit shown in FIG. 1.

The amplifier circuit 61 according to this embodiment includes the first operational amplifier OPC1 and the second operational amplifier OPC2. The amplifier circuit 61 may include a gain setting section 63.

The input signal VS2 is input to the non-inverting input terminal (first input terminal) of the first operational amplifier OPC1. The output (VS4) from the operational amplifier OPC1 is input to the non-inverting input terminal (first input terminal) of the second operational amplifier OPC2. The output (VS3) from the operational amplifier OPC2 is input to the inverting input terminal (second input terminal) of the operational amplifier OPC2 and the inverting input terminal (second input terminal) of the operational amplifier OPC1. Specifically, the operational amplifier OPC2 is a voltage-follower-connected operational amplifier.

The gain setting section 63 sets the gain of the amplifier circuit 61. The gain setting section 63 includes a first capacitor CC1 and a second capacitor CC2. Specifically, the first capacitor CC1 is provided between the output of the operational amplifier OPC1 and the inverting input terminal (second input terminal) of the operational amplifier OPC1. The second capacitor CC2 is provided between the output of the operational amplifier OPC2 and the power supply VSS (first power supply in a broad sense). The configuration of the gain setting section 63 is not limited to the configuration shown in FIG. 7. Various modifications may be made such as changing the connection relationship or changing the circuit elements.

In this embodiment, a high-speed operational amplifier is used as the operational amplifier OPC1, and a low-speed operational amplifier is used as the operational amplifier OPC2, for example. Specifically, a bias current that flows through the operational amplifier OPC1 is increased as compared with that of the operational amplifier OPC2, or the gate length of a transistor of the operational amplifier OPC1 is reduced as compared with that of the operational amplifier OPC2. For example, when a first bias current that flows through the operational amplifier OPC1 is referred to as IB1 and a second bias current that flows through the operational amplifier OPC2 is referred to as IB2, the first bias current IB1 is set to be larger than the second bias current IB2. For example, the bias current IB2 is set to be about 1/10th to 1/40th of the bias current IB1. Specifically, a high-speed operational amplifier which operates even in a high frequency band is used as the operational amplifier OPC1, and a low-speed operational amplifier which operates only in a low frequency band is used as the operational amplifier OPC2. This provides the amplifier circuit 61 with band-pass filter frequency characteristics.

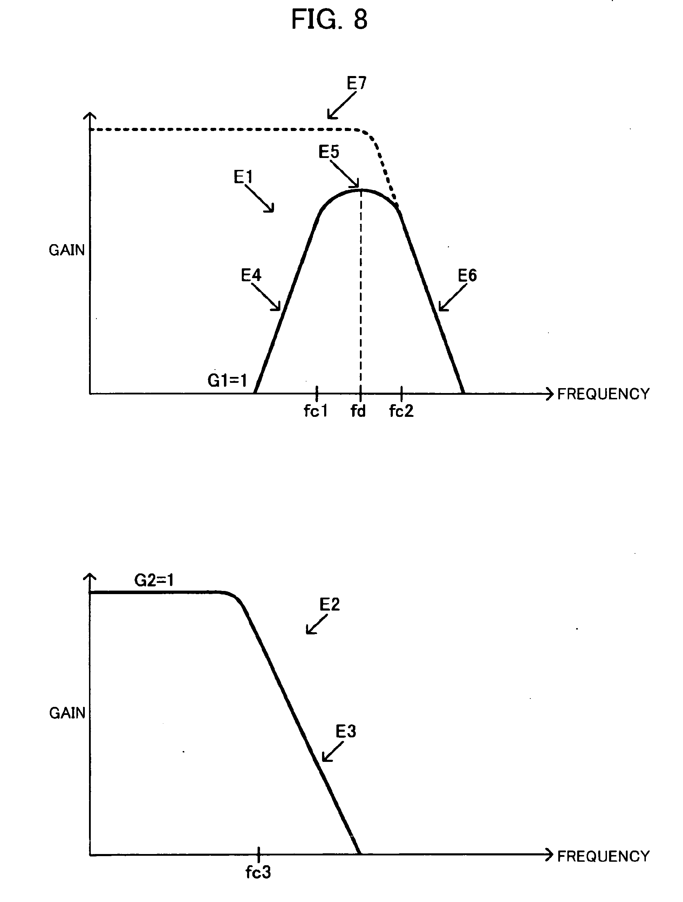

In FIG. 8, E1 indicates the band-pass filter characteristics of the amplifier circuit 61, and E2 indicates the low-pass filter characteristics of the operational amplifier OPC2. The operational amplifier OPC2 is a low-speed operational amplifier with a small bias current IB2, and has low-pass filter characteristics indicated by E2. Therefore, the operational amplifier OPC2 functions as a voltage-follower-connected operational amplifier (gain G2=1) in a frequency band lower than a cut-off frequency fc3, but does not function as a voltage-follower-connected operational amplifier in a frequency band sufficiently higher than the cut-off frequency fc3.

The operational amplifier OPC2 functions as a voltage-follower-connected operational amplifier in a frequency band lower than the cut-off frequency fc3. Therefore, the signal VS4 output from the operational amplifier OPC1 is fed back to the inverting input terminal of the operational amplifier OPC1 as the input signal VS3 through the voltage-follower-connected operational amplifier OPC2. Accordingly, the operational amplifier OPC 1 also functions as a voltage-follower-connected operational amplifier so that the gain G1 of the amplifier circuit 61 is set at about one.

When the gain G2 of the operational amplifier OPC2 decreases as the frequency of the signal increases, as indicated by E3 in FIG. 8, the operational amplifier OPC2 gradually stops functioning as a voltage-follower-connected operational amplifier. Therefore, the gain G1 of the amplifier circuit 61 gradually increases, as indicated by E4.

When the frequency of the signal has become sufficiently higher than the cut-off frequencies fc3 of the operational amplifier OPC2, the operational amplifier OPC2 does not function as a voltage-follower-connected operational amplifier (i.e., the presence of the operational amplifier OPC2 is disregarded). In this case, the amplifier circuit 61 is equivalent to a circuit formed by the operational amplifier OPC1 and the capacitors CC1 and CC2. Therefore, when the capacitances of the capacitors CC1 and CC2 are referred to as C1 and C2, respectively, the gain G1 of the amplifier circuit 61 is set at C1/C2. Specifically, the gain G1 of the amplifier circuit 61 at the band-pass peak frequency fd (frequency of the desired signal or carrier) indicated by E5 in FIG. 8 is set at C1/C2. The gain G1 of the amplifier circuit 61 gradually decreases as the frequency of the signal becomes higher than the frequency fd, as indicated by E6. The band-pass filter characteristics indicated by E4, E5, and E6 are set in this manner.

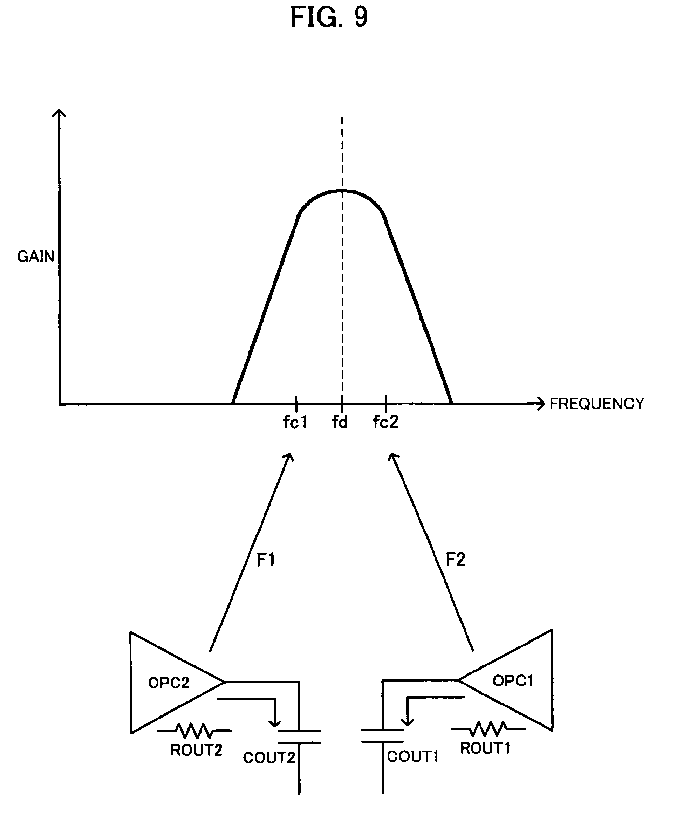

As indicated by F1 in FIG. 9, the low-frequency-side cut-off frequency fc1 of the band-pass filter of the amplifier circuit 61 is set based on an output impedance ROUT2 of the operational amplifier OPC2 and a load capacitance COUT2 of the output node NA3 of the operational amplifier OPC2. Specifically, the low-pass filter attenuation characteristics of the operational amplifier OPC2 indicated by E3 in FIG. 8 are determined by the output impedance ROUT2 of the operational amplifier OPC2 and the load capacitance COUT2 of the node NA3. The band-pass filter attenuation characteristics of the amplifier circuit 61 indicated by E4 are determined by the low-pass filter attenuation characteristics of the operational amplifier OPC2 indicated by E3. Therefore, the low-frequency-side cut-off frequency fc1 of the band-pass filter is determined by the output impedance ROUT2 of the operational amplifier OPC2 and the load capacitance COUT2.

The output impedance ROUT2 (current supply capability) of the operational amplifier OPC2 is determined by the bias current of the operational amplifier OPC2, the gate length of the transistor of the operational amplifier OPC2, and the like. For example, the output impedance ROUT2 decreases as the bias current increases or the gate length decreases.

The load capacitance COUT2 of the node NA3 is determined by the capacitances of the capacitors CC1 and CC2, the gate capacitance of the inverting input terminal of the operational amplifier OPC1, the drain capacitance of the transistor of the operational amplifier OPC2, the parasitic capacitance of the wiring of the node NA3, and the like.

As indicated by F2 in FIG. 9, the high-frequency-side cut-off frequency fc2 of the band-pass filter is set based on an output impedance ROUT1 of the operational amplifier OPC1 and a load capacitance COUT1 of the output node NA4 of the operational amplifier OPC1. Specifically, the low-pass filter attenuation characteristics indicated by E7 in FIG. 8 are determined by the output impedance ROUT1 of the operational amplifier OPC1 and the load capacitance COUT1 of the node NA4. The band-pass filter attenuation characteristics of the amplifier circuit 61 indicated by E6 are determined by the low-pass filter attenuation characteristics of the operational amplifier OPC1 indicated by E7. Therefore, the high-frequency-side cut-off frequency fc2 of the band-pass filter is determined by the output impedance ROUT1 of the operational amplifier OPC1 and the load capacitance COUT1 of the node NA4.

The output impedance ROUT1 of the operational amplifier OPC1 is determined by the bias current of the operational amplifier OPC1, the gate length of the transistor of the operational amplifier OPC1, and the like. The load capacitance COUT1 of the node NA4 is determined by the capacitance of the capacitor CC1, the gate capacitance of the non-inverting input terminal of the operational amplifier OPC2, the drain capacitance of the transistor of the operational amplifier OPC1, the parasitic capacitance of the wiring of the node NA4, and the like.

According to this embodiment, since a high-speed operational amplifier with a large bias current is used as the operational amplifier OPC1 and a low-speed operational amplifier with a small bias current is used as the operational amplifier OPC2, the band-pass filter characteristics shown in FIG. 8 can be implemented. This allows only a signal in the band of the frequency fd of the desired signal (carrier) to pass through while removing signals (e.g., noise signal) in the remaining frequency band, whereby the S/N ratio and the like can be improved. Moreover, the amplifier circuit 61 can be provided with an amplification function and a band-pass filter function. This makes it unnecessary to provide a band-pass filter separately from the amplifier circuit 61, whereby the circuit scale can be reduced. Moreover, power consumption can be reduced due to a reduction in the number of circuit elements.

5. Rail-to-rail operational amplifier

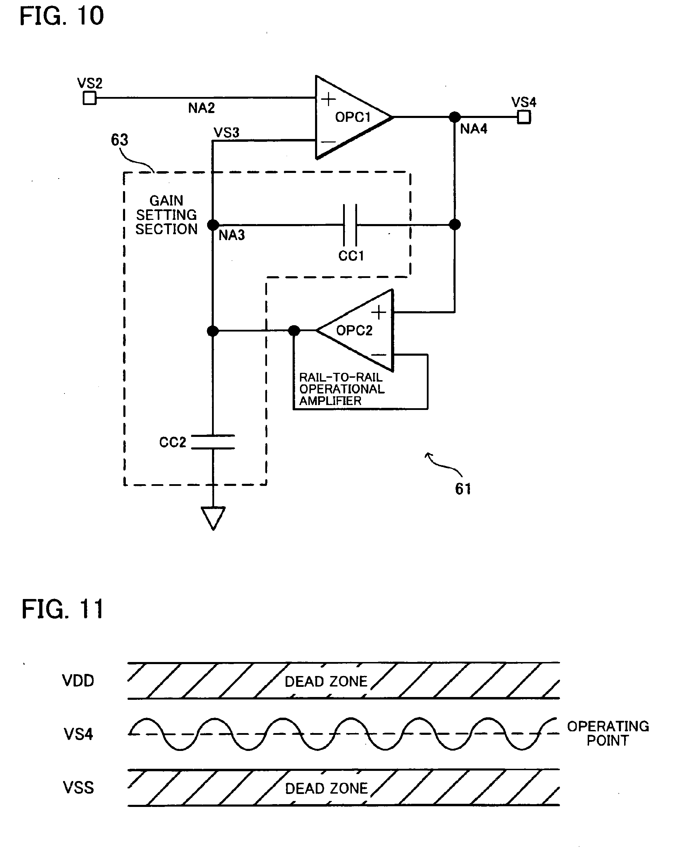

In this embodiment, a rail-to-rail operational amplifier may be used as the operational amplifier OPC2 of the amplifier circuit 61, as shown in FIG. 10. Note that an operational amplifier other than a rail-to-rail operational amplifier may also be used as the operational amplifier OPC2.

In FIG. 11, the signal VS4 output from the operational amplifier OPC1 is a signal having a given amplitude with respect to the small-signal amplification operating point, for example. If the operational amplifier OPC2 to which the output signal VS4 is input is not a rail-to-rail operational amplifier, dead zones are formed in the upper side and the lower side of the power supply range between the power supply voltages (levels) VSS and VDD. These dead zones prevent the operational amplifier OPC2 from performing an appropriate signal amplification operation.

As described with reference to FIG. 8, the operational amplifier OPC2 operates as a voltage-follower-connected operational amplifier in a low frequency band (e.g., DC band), and feeds back the signal VS4 output from the operational amplifier OPC1 to the inverting input terminal of the operational amplifier OPC1. Therefore, in order to stabilize the voltage level of the operating point for the output signal VS4, it is necessary to cause the operational amplifier OPC2 to appropriately feed back the signal in the DC band.

On the other hand, if the operational amplifier OPC2 is not a rail-to-rail operational amplifier, the operational amplifier OPC2 does not appropriately feed back the signal to the inverting input terminal of the operational amplifier OPC1 in the dead zone shown in FIG. 11. Therefore, the operating point for the output signal VS4 is shifted to the power supply voltage VDD or VSS, whereby an appropriate small-amplitude signal amplification operation cannot be implemented.

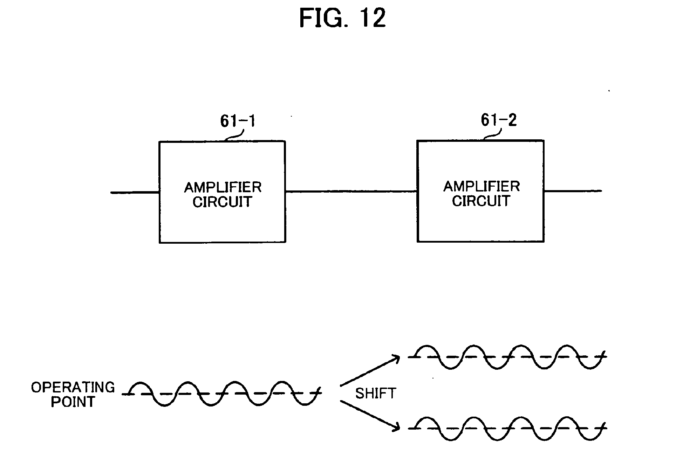

As shown in FIG. 12, a plurality of amplifier circuits 61-1 and 61-2 may be cascaded in order to achieve a high amplification factor. However, the operating point is further shifted by cascading a plurality of amplifier circuits. This may cause a situation in which the operating point reaches the dead zone and cannot recover from the dead zone.

According to this embodiment, a rail-to-rail operational amplifier is used as the operational amplifier OPC2. Therefore, the signal can be amplified in a well-balanced manner with respect to the operating point. As a result, imbalance relating to signal feedback from the output of the operational amplifier OPC1 to the inverting input terminal of the operational amplifier OPC1 can be reduced, whereby a situation in which the center level of the signal VS4 is shifted can be prevented. This enables a stable signal amplification operation to be implemented even when cascading a plurality of amplifier circuits 61-1 and 61-2, as shown in FIG. 12. This embodiment also prevents a situation in which the center level of the signal output to the circuit in the subsequent stage of the amplifier circuit (e.g., demodulator circuit described later) is shifted, thereby making it difficult for the circuit in the subsequent stage to perform a process.

6. First configuration example

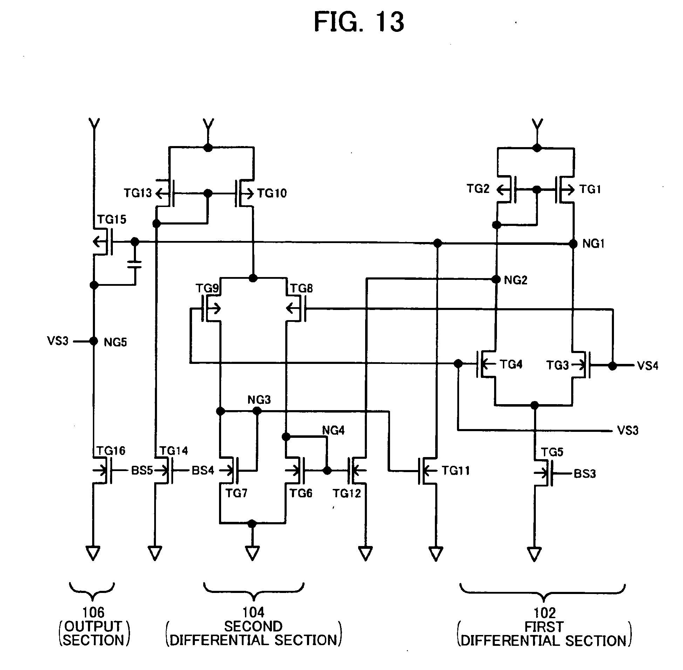

FIG. 13 shows a first configuration example of the rail-to-rail operational amplifier OPC2. The operational amplifier OPC2 includes first and second differential sections 102 and 104, an output section 106, and first and second transistors TG11 and TG12.

The first differential section 102 includes a first current-mirror circuit that includes transistors TG1 and TG2, first differential-pair transistors TG3 and TG4, and a first current source transistor TG5. The transistors TG1 and TG2 are P-type transistors, and the transistors TG3, TG4, and TG5 are N-type transistors.

The second differential section 104 includes a second current-mirror circuit that includes transistors TG6 and TG7, second differential-pair transistors TG8 and TG9, and a second current source transistor TG10. The transistors TG6 and TG7 are N-type transistors, and the transistors TG8, TG9, and TG10 are P-type transistors. Transistors TG13 and TG14 form a circuit that generates a bias voltage of the transistor TG10.

The output from the differential section 102 is input to the output section 106. Specifically, the output section 106 includes a P-type transistor TG15 to which the output from the differential section 102 is supplied at its gate, and an N-type transistor TG16 to which a bias voltage BS5 is supplied at its gate.

The first transistor TG11 is provided between a first node NG1 and the power supply VSS (first power supply). The first node NG1 is a drain node of the transistor TG3 of the first differential-pair transistors of the first differential section 102. The node NG1 is connected to the gate of the transistor TG15 of the output section 106. A third node NG3 is connected to the gate of the transistor TG11. The node NG3 is a drain node of the transistor TG9 of the second differential-pair transistors of the second differential section 104.

The second transistor TG12 is provided between a second node NG2 and the power supply VSS. The second node NG2 is a drain node of the transistor TG4 of the first differential-pair transistors. A fourth node NG4 is connected to the gate of the transistor TG12. The node NG4 is a drain node of the transistor TG8 of the second differential-pair transistors.

In FIG. 13, the gate of the transistor TG3 of the first differential-pair transistors is connected to the gate of the transistor TG8 of the second differential-pair transistors. Specifically, the signal VS4 is input to the gates of these transistors. The gate of the transistor TG4 of the first differential-pair transistors is connected to the gate of the transistor TG9 of the second differential-pair transistors. Specifically, the signal VS3 output from the output section 106 is input to the gates of these transistors.

In FIG. 13, when the voltage of the signal VS4 has decreased and the N-type transistor TG3 of the differential section 102 has been turned OFF, since the P-type transistor TG8 of the differential section 104 is turned ON, the signal VS4 can be amplified using the differential section 104. Therefore, a situation in which a dead zone is formed on the lower side of the power supply voltage range can be prevented.

In FIG. 13, when the voltage of the signal VS4 has increased and the P-type transistor TG8 of the differential section 104 has been turned OFF, since the P-type transistor TG3 of the differential section 102 is turned ON, the signal VS4 can be amplified using the differential section 102. Therefore, a situation in which a dead zone is formed on the upper side of the power supply voltage range can be prevented.

According to the configuration shown in FIG. 13, a situation in which a dead zone is formed on the lower side and the upper side of the power supply voltage range can be prevented so that a rail-to-rail operational amplifier can be implemented. Therefore, the signal can be amplified in a well-balanced manner with respect to the operating point. As a result, imbalance relating to signal feedback from the output of the operational amplifier OPC1 to the inverting input terminal of the operational amplifier OPC1 can be reduced, whereby a situation in which the operating point is shifted can be prevented.

7. Second configuration example

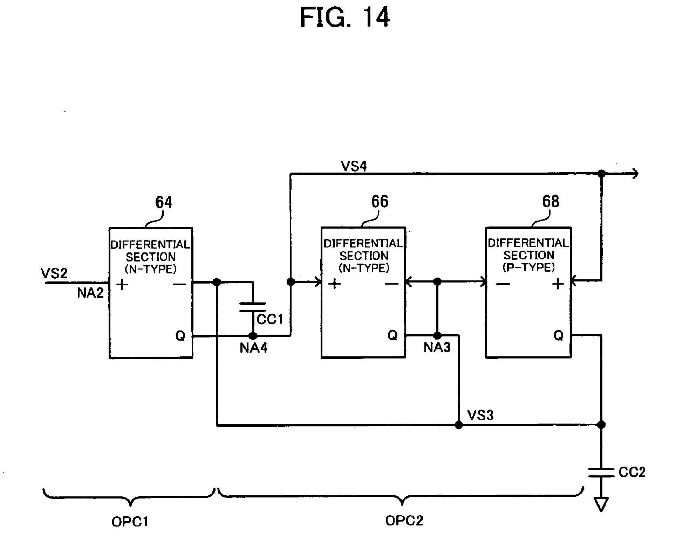

FIG. 14 shows a second configuration example of the rail-to-rail operational amplifier OPC2 and a configuration example of the operational amplifier OPC1.

In FIG. 14, the operational amplifier OPC1 includes a differential section (differential stage), but does not include an output section (output stage). The operational amplifier OPC2 includes first and second differential sections 66 and 68. Each differential section does not include an output section.

The output (NA4 or VS4) of the differential section 64 of the operational amplifier OPC1 is connected to non-inverting input terminals (first input terminals) of the differential sections 66 and 68 of the operational amplifier OPC2. Specifically, the output of the differential section 64 is connected to the gate of one of differential-pair transistors. The output of the differential section 66 is connected to the output of the differential section 68. The outputs (NA3 or VS3) of the differential sections 66 and 68 are connected to inverting input terminals (second input terminals) of the differential sections 66 and 68. Specifically, the outputs of the differential sections 66 and 68 are connected to the gate of the other transistor of the differential-pair transistors.

Power consumption can be reduced by employing the operational amplifiers which include only the differential section 64 or the differential sections 66 and 68 and do not include an output section as the operational amplifiers OPC1 and OPC2.

In the first configuration example shown in FIG. 13, since a current flows through the output section 106 and the first and second transistors TG11 and TG12, the current consumption of the operational amplifier increases. On the other hand, since a current that flows through the output section and the like can be reduced by employing the configuration shown in FIG. 14 in which the output section and the like are not provided, power consumption can be reduced.

In FIG. 14, the low-pass filter attenuation characteristics of the operational amplifier OPC2 indicated by E3 in FIG. 8 are implemented by reducing the bias current IB2 that flows through the differential sections 66 and 68 as far as possible, whereby the band-pass filter attenuation characteristics of the amplifier circuit 61 indicated by E4 are implemented. Specifically, since the band-pass filter frequency characteristics are implemented by causing the voltage-follower-connected operational amplifier OPC2 to be absent in a high frequency band, the bias current that flows through the differential sections 66 and 68 is reduced to about several nA, for example. Therefore, a shoot-through current which occurs when short-circuiting the outputs of the differential sections 66 and 68 is as small as about several nA.

In FIG. 14, the low-pass filter attenuation characteristics of the operational amplifier OPC1 indicated by E7 in FIG. 8 are implemented by setting the bias current IB1 that flows through the differential section 64 to be larger than the bias current IB2 that flows through the differential sections 66 and 68, whereby the band-pass filter attenuation characteristics of the amplifier circuit 61 indicated by E6 are implemented. Since the bias current IB1 is large, the load capacitance of the output of the differential section 64 can be sufficiently driven even if the output section is not provided in the differential section 64.

According to the configuration of FIG. 14, the amplifier circuit 61 can be provided with an amplification function and a band-pass filter function while reducing power consumption.

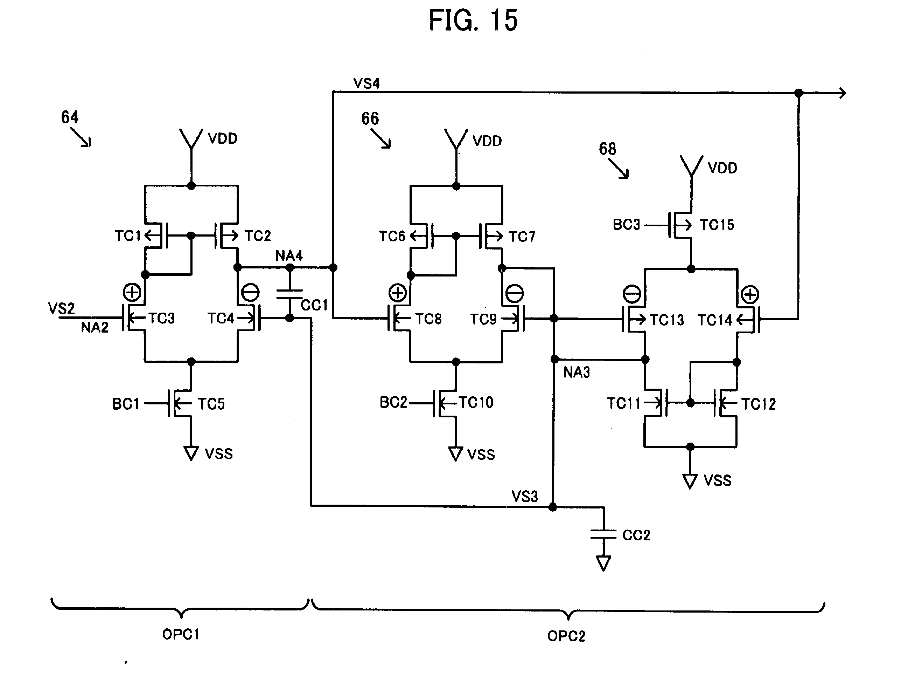

FIG. 15 shows a detailed configuration example of the differential sections 64, 66, and 68. The differential sections 64, 66, and 68 are not limited to the configuration shown in FIG. 15. Various modifications may be made such as omitting some elements or adding another element.

As shown in FIG. 15, the differential section 64 of the operational amplifier OPC1 includes a current-mirror circuit that includes transistors TC1 and TC2. The differential section 64 also includes differential-pair transistors TC3 and TC4, the input signal VS2 being input to the gate of the transistor TC3, and the outputs (NA3) of the first and second differential sections 66 and 68 being connected to the gate of the transistor TC4. The differential section 64 also includes a current source transistor TC5 which supplies a bias current which flows through the current-mirror circuit (TC1 and TC2) and the differential-pair transistors TC3 and TC4.

In FIG. 15, the transistors TC 1 and TC2 are P-type transistors, and the transistors TC3, TC4, and TC5 are N-type transistors. A bias voltage BC1 is input to the gate of the transistor TC5.

The first differential section 66 of the operational amplifier OPC2 includes a first current-mirror circuit that includes P-type transistors TC6 and TC7. The first differential section 66 also includes first differential-pair transistors TC8 and TC9, the output (NA4) of the differential section 64 being connected to the gate of the N-type transistor TC8, and the outputs (NA3) of the first and second differential sections 66 and 68 being connected to the gate of the N-type transistor TC9. The first differential section 66 also includes a first current source transistor TC10 which supplies a bias current which flows through the first current-mirror circuit (TC6 and TC7) and the first differential-pair transistors TC8 and TC9 and is formed using an N-type transistor.

The second differential section 68 of the operational amplifier OPC2 includes a second current-mirror circuit that includes N-type transistors TC11 and TC12. The second differential section 68 also includes second differential-pair transistors TC13 and TC14, the output (NA4) of the differential section 64 being connected to the gate of the P-type transistor TC14, and the outputs (NA3) of the first and second differential sections 66 and 68 being connected to the gate of the P-type transistor TC13. The second differential section 68 also includes a second current source transistor TC15 which supplies a bias current which flows through the second current-mirror circuit (TC11 and TC12) and the second differential-pair transistors TC13 and TC14 and is formed using a P-type transistor.

In FIG. 15, a rail-to-rail operational amplifier can be formed by the differential sections 66 and 68.

Specifically, the small-signal amplification operating point (amplification center level) of the signal VS4 output to the node NA4 is set at 0.8 to 1.0 V, for example. Therefore, when only the differential section 66 is provided in the operational amplifier OPC2, the N-type transistor TC8 of the differential section 66 may be turned OFF in a voltage range lower than the operating point, whereby a dead zone may be formed on the lower side of the power supply voltage range.

In FIG. 15, the differential section 68 is provided in addition to the differential section 66. Therefore, since the P-type transistor TC 14 of the differential section 68 is tuned ON even if the voltage of the node NA4 has decreased, the signal VS4 can be amplified using the differential section 68. Therefore, a situation in which a dead zone is formed on the lower side of the power supply voltage range can be prevented.

When only the differential section 68 is provided in the operational amplifier OPC2, the P-type transistor TC14 of the differential section 68 may be turned OFF in a voltage range higher than the operating point, whereby a dead zone may be formed on the upper side of the power supply voltage range.

In FIG. 15, the differential section 66 is provided in addition to the differential section 68. Therefore, since the N-type transistor TC8 of the differential section 66 is tuned ON even if the voltage of the node NA4 has increased, the signal VS4 can be amplified using the differential section 66. Therefore, a situation in which a dead zone is formed on the upper side of the power supply voltage range can be prevented.

According to the configuration shown in FIG. 15, a situation in which a dead zone is formed on the lower side and the upper side of the power supply voltage range can be prevented. Therefore, a rail-to-rail operational amplifier can be implemented so that a signal can be amplified in a well-balanced manner with respect to the operating point. As a result, imbalance relating to signal feedback from the output of the operational amplifier OPC1 to the inverting input terminal of the operational amplifier OPC1 can be reduced, whereby a situation in which the center level of the signal VS4 is shifted can be prevented.

The bias current IB2 that flows through the differential sections 66 and 68 is reduced as far as possible, as described above. Specifically, the W/L (gate width/gate length) ratio of the current source transistor TC10 is reduced as far as possible (e.g., W/L=1/10 to 1/30). Moreover, the W/L ratio of the transistor TC15 is reduced, and the W/L ratio of the N-type transistor which generates a bias voltage BC3 of the transistor TC15 is reduced as far as possible. Therefore, the bias current IB2 is reduced to several nA, for example.

Therefore, even if a shoot-through current flows through a path from the power supply VDD to the power supply VSS through the transistors TC7 and TC11 or a path from the power supply VDD to the power supply VSS through the transistors TC15, TC 13, TC9, and TC10, the shoot-through current is as small as several nA, for example. Therefore, an adverse effect due to a shoot-through current can be practically disregarded even when short-circuiting the outputs of the differential sections 66 and 68, as shown in FIG. 15. Since the output section and the like need not be provided in the operational amplifier OPC2 by short-circuiting the outputs of the differential sections 66 and 68, power consumption and the circuit scale can be reduced.

8. Offset voltage

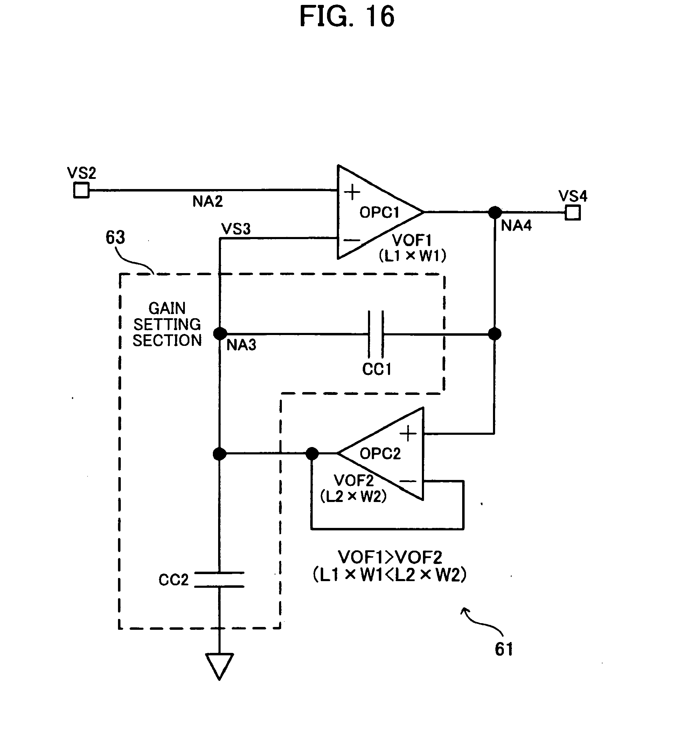

In this embodiment, when the offset voltage of the operational amplifier OPC1 is referred to as VOF1 and the offset voltage of the operational amplifier OPC2 is referred to as VOF2, the offset voltage VOF1 is set to be higher than the offset voltage VOF2 (VOF1>VOF2), as shown in FIG. 16. Specifically, when the gate length and the gate width of the differential-pair transistors TC3 and TC4 of the operational amplifier OPC1 are respectively referred to as L1 and W1 and the gate length and the gate width of the differential-pair transistors TC8 and TC9 of the operational amplifier OPC2 are respectively referred to as L2 and W2, the product $L1 \times W1$ is set to be smaller than the product $L2 \times W2$ ($L1 \times W1 < L2 \times W2$).

For example, a high amplification factor can be obtained by cascading a plurality of amplifier circuits shown in FIG. 7 or the like. In this case, if the offset voltage of each amplifier circuit is high, an appropriate amplification operation may not be implemented due to a shift in the operating point.

A method may be considered which eliminates the effects of the offset voltage by providing a DC-cut capacitor between the amplifier circuit in the first stage and the amplifier circuit in the second stage. According to this method, since it is necessary to increase the current supply capability of the operational amplifier OPC1 in order to charge and discharge the DC-cut capacitor, power consumption increases.

Therefore, in order to prevent a shift in the operating point while reducing power consumption, it is desirable to reduce the offset voltage by increasing the product $L \times W$ (=L2xW2) of the differential-pair transistors of the operational amplifier OPC2 (OPC4) and directly connect a plurality of amplifier circuits without using a DC-cut capacitor.

In this embodiment, a high-speed operational amplifier is used as the operational amplifier OPC1 and a low-speed operational amplifier is used as the operational amplifier OPC2 in order to reduce power consumption, as described above. Therefore, if the product $L \times W$ (=L1 $\times$ W1) of the differential-pair transistor TC4 of the operational amplifier OPC1 is increased in order to reduce the offset voltage, the drain capacitance of the transistor TC4 increases, whereby an increase in operation speed of the operational amplifier OPC 1 is hindered.

On the other hand, if the product $L \times W$ (=L2 $\times$ W2) of the differential-pair transistors TC8 and TC9 of the operational amplifier OPC2 is increased in order to reduce the offset voltage, a serious problem does not occur since it suffices that the operational amplifier OPC2 operate at low speed.

In this embodiment, the offset voltage VOF2 of the operational amplifier OPC2 is reduced by increasing the product $L2 \times W2$ of the differential-pair transistors TC8 and TC9 of the operational amplifier OPC2. On the other hand, the offset voltage VOF1 of the operational amplifier OPC1 is set to be higher than the offset voltage VOF2 by increasing the product $L1 \times W1$ of the differential-pair transistor TC4 of the operational amplifier OPC1. This enables a shift in the operating point to be prevented while reducing power consumption.

9. Layout

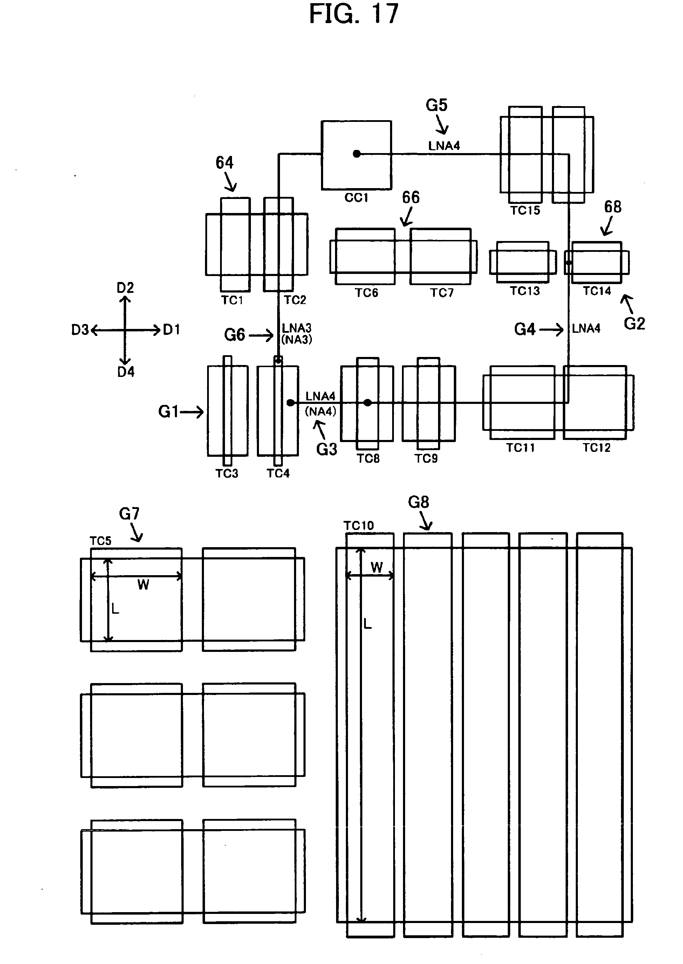

FIG. 17 shows a layout example of the amplifier circuit according to this embodiment. FIG. 17 shows a layout corresponding to the detailed configuration example shown in FIG. 15. In FIG. 17, the rightward direction is a direction D1 (first direction), the upward direction is a direction D2 (second direction), the leftward direction is a direction D3 (third direction), and the downward direction is a direction D4 (fourth direction). Note that these directions are arbitrary. For example, the leftward direction may be the direction D1, and the downward direction may be the direction D2.

As indicated by G1 in FIG. 17. the differential-pair transistors TC3 and TC4 of the differential section 64, the first differential-pair transistors TC8 and TC9 of the first differential section 66, and the transistors TC11 and TC12 of the second current-mirror circuit of the second differential section 68 shown in FIG. 15 are disposed along the direction D1. Specifically, the transistors TC8 and TC9 are disposed in the direction D1 with respect to the transistors TC3 and TC4, and the transistors TC11 and TC12 are disposed in the direction D1 with respect to the transistors TC8 and TC9.

When the direction perpendicular to the direction D1 is referred to as the direction D2, the second differential-pair transistors TC13 and TC14 of the second differential section 68 are disposed in the direction D2 with respect to the transistors TC11 and TC12 of the second current-mirror circuit. Specifically, the N-type transistors TC11 and TC12 are formed in an N-type transistor region (P well) together with the N-type transistors TC3, TC4, TC8, and TC9. The P-type transistors TC13 and TC14 are formed in a P-type transistor region (N well) together with the P-type transistors TC1, TC2, TC6, and TC7.

Since the differential sections 64, 66, and 68 can be compactly disposed along the direction D1 by disposing the transistors in this manner, the layout area of the amplifier circuit can be reduced. Moreover, since signal lines that connect the differential sections 64, 66, and 68 can be provided along a short path, the wiring length and the parasitic capacitance can be reduced.

As indicated by G3 in FIG. 17, an output line LNA4 (node NA4) of the differential section 64 is provided along the direction D1 from the differential-pair transistors TC3 and TC4 of the differential section 64 toward the transistors TC11 and TC12 of the second current-mirror circuit of the differential section 68.

As indicated by G4, the output line LNA4 is provided along the direction D2 from the transistors TC11 and TC12 of the second current-mirror circuit of the differential section 68 toward the second differential-pair transistors TC13 and TC14 of the differential section 68. The output line LNA4 thus provided is connected to the drain of the transistor TC4 and connected to the gates of the transistors TC8 and TC 14.

According to this configuration, an amplifier circuit having the connection configuration shown in FIG. 15 can be implemented by efficiently connecting the output line LNA4 of the differential section 64 to the drain of the transistor TC4 and the gates of the transistors TC8 and TC14 along the directions D1 and D2. Moreover, since the length of the output line LNA4 can be reduced, the parasitic capacitance of the output line LNA4 can be reduced.

When the direction opposite to the direction D1 is referred to as the direction D3 and the direction opposite to the direction D2 is referred to as the direction D4, the output line NLA4 of the differential section 64 is provided along the direction D3 from the differential-pair transistors TC 13 and TC 14 toward the capacitor CC 1 and connected to one end of the capacitor CC1, as indicated by G5 in FIG. 17.

As indicated by G6, a connection line LNA3 (node NA3) from the other end of the capacitor CC 1 is provided along the direction D4 from the capacitor CC 1 toward the differential-pair transistors TC3 and TC4 of the differential section 64 and connected to the gate of the transistor TC4.

According to this configuration, the output line LNA4 from the transistor TC4 is provided approximately in the shape of the letter "C" and is connected to one end of the capacitor CC1, as shown in FIG. 17, and the connection line LNA3 from the other end of the capacitor CC2 is connected (returns) to the transistor TC4. Specifically, the output line LNA4 and the connection line LNA3 are effectively provided approximately in the shape of a quadrangle. Moreover, since the transistors and the capacitor CC 1 of the differential sections 64, 66, and 68 can be provided compactly, the layout area can be reduced.

In this embodiment, a high-speed operational amplifier is used as the operational amplifier OPC1 formed using the differential section 64 in order to implement band-pass filter characteristics and improve response. Specifically, the bias current IB 1 that flows through the transistor TC5 is sufficiently increased as compared with the bias current IB2 that flows through the transistor TC10, and the gate length of the transistors TC1 to TC4 is reduced.

However, even if the bias current IB1 is increased, an increase in operation speed of the operational amplifier OPC1 is hindered when the load capacitance of the node NA4 is large.

In FIG. 17, the output line LNA4 of the node NA4 is connected to the gates of the transistors TC8 and TC14 and one end of the capacitor CC1 at the shortest distance by preventing the output line LNA4 from being provided along a roundabout path. Therefore, since the length of the output line LNA4 can be minimized so that the parasitic capacitance of the output line LNA4 can be reduced, the operation speed of the operational amplifier OPC1 can be increased.

As indicated by G7 in FIG. 17, the current source transistor TC5 of the differential section 64 is disposed in the direction D4 with respect to the differential-pair transistors TC3 and TC4. As indicated by G8, the current source transistor TC10 of the differential section 66 (and the transistor which generates the bias voltage of the transistor TC15) is disposed in the direction D4 with respect to the differential-pair transistors TC8 and TC9. This enables an efficient layout.

Specifically, the gate width W of the current source transistor TC5 of the differential section 64 is set at a large value in order to increase the operation speed of the operational amplifier OPC1. The gate length L of the current source transistor TC5 is also set at a large value in order to stabilize a constant current that flows through the transistor TC5. Therefore, the product $L \times W$ (i.e., gate area) of the current source transistor TC5 increases, as indicated by G7 in FIG. 17.

The gate length L of the current source transistor TC10 of the differential section 66 is set at a very large value in order to decrease the operation speed of the operational amplifier OPC2 to reduce current. Therefore, the product $L \times W$ (i.e., gate area) of the current source transistor TC10 (and the N-type transistor which generates the bias voltage of the transistor TC15) increases, as indicated by G10 in FIG. 17.

In FIG. 17, the transistor TC5 is disposed utilizing the space in the direction D4 with respect to the transistors TC3 and TC4, and the transistor TC10 is disposed utilizing the space in the direction D4 with respect to the transistors TC8 and TC9. Therefore, the transistors can be disposed efficiently, whereby the layout area can be reduced.

In FIG. 17, the length of the output line LNA4 is reduced by collectively disposing the transistors TC1 to TC4, TC6 to TC9, and TC11 to TC14 to reduce the parasitic capacitor of the output line LNA4. On the other hand, the transistors TC5 and TC10 having a large product $L \times W$ are disposed in the space in the direction D4 with respect to the transistors TC1 to TC4, TC6 to TC9, and TC11 to TC14. This enables the transistors of the operational amplifiers to be disposed compactly and efficiently while reducing the wiring length, whereby the layout efficiency can be improved while improving the circuit characteristics.

10. Modification of receiver circuit

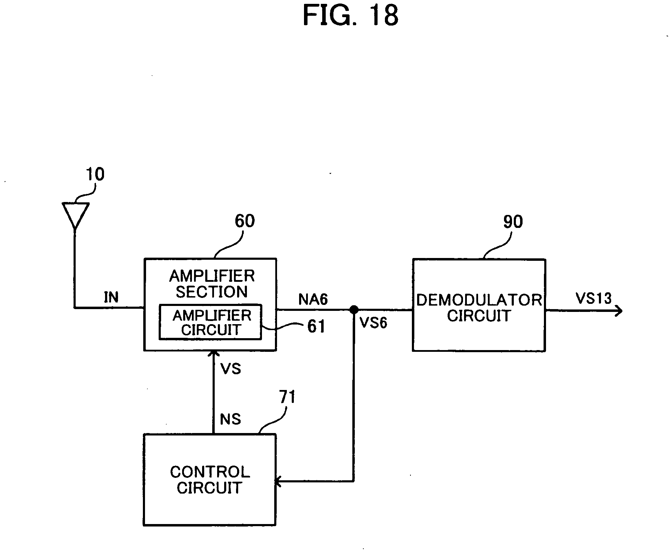

FIG. 18 shows a modification of the receiver circuit. In FIG. 18, the amplifier section 60 includes the amplifier circuit according to this embodiment described with reference to FIGS. 7, 10, 13 to 15, and the like. The amplifier section 60 is provided with an automatic gain adjustment function instead of providing the attenuator.

Specifically, the control circuit 71 detects the amplitude of the signal VS6 output from the amplifier section 60. The control circuit 71 outputs the gain adjustment control signal VS to the amplifier section 60 based on the amplitude detection result. The amplifier section 60 then performs an automatic gain adjustment based on the control signal VS so that the amplitude of the signal VS6 becomes constant. The amplifier section 60 outputs the signal VS6 obtained by the automatic gain adjustment to the demodulator circuit 90. The demodulator circuit 90 demodulates the modulated signal based on the signal VS6.

According to this embodiment, since the amplifier circuit 61 can also be provided with a band-pass filter function and an amplification function when using the configuration shown in FIG. 18, it is unnecessary to separately provide a band-pass filter. Therefore, the circuit scale and power consumption can be reduced.

Although the embodiments of the invention have been described in detail above, those skilled in the art would readily appreciate that many modifications are possible in the embodiments without materially departing from the novel teachings and advantages of the invention. Accordingly, such modifications are intended to be included within the scope of the invention. Any term (e.g. VSS, VDD, and logic level 1) cited with a different term (e.g., first power supply, second power supply, and first logic level) having a broader meaning or the same meaning at least once in the specification and the drawings can be replaced by the different term in any place in the specification and the drawings. The configurations and the operations of the receiver circuit and the amplifier circuit are not limited to those described with reference to the above embodiments. Various modifications and variations may be made.

**Claims**

1. A receiver circuit comprising:

   an attenuator that receives a received signal and attenuates the received signal;
   a DC level shifter that shifts a DC level of an attenuated signal from the attenuator;
   an amplifier section that has frequency characteristics of a band-pass filter and amplifies a signal from the DC level shifter that has been shifted with respect to the DC level; and
   a control circuit that controls an attenuation of the attenuator based on a signal output from the amplifier section, the control circuit controlling the attenuation of the attenuator by changing filter characteristics of the attenuator corresponding to an amplitude of the signal output from the amplifier section so that the signal output from the amplifier section has a constant amplitude even when an amplitude of the received signal has changed.

2. The receiver circuit as defined in claim 1,
   the attenuator having characteristics of a high-pass filter; and
   the control circuit controlling the attenuation of the attenuator by changing a cut-off frequency of the high-pass filter corresponding to the amplitude of the signal output from the amplifier section.

3. The receiver circuit as defined in claim 2,
   the control circuit increasing the attenuation of the attenuator in a frequency band of a carrier of the received signal by increasing the cut-off frequency of the high-pass filter as the amplitude of the signal output from the amplifier section increases.

4. The receiver circuit as defined in any one of claims 1 to 3,
   the control circuit including a charge capacitor provided between a charge node and a first power supply, and a charge transistor provided between the charge node and a second power supply, the control circuit comparing the amplitude of the signal output from the amplifier section with a reference voltage, charging the charge capacitor using the charge transistor based on a comparison result, and outputting a voltage of the charge node to the attenuator as a control voltage.

5. The receiver circuit as defined in claim 4,
   the control circuit including a discharge transistor that is provided between the charge node and the first power supply and allows a constant current to flow toward the first power supply.

**6.** The receiver circuit as defined in claim 5,
a discharge period set based on the constant current that flows through the discharge transistor and a capacitance of the charge capacitor being longer than a transfer period of a first logic level of the received signal that is ASK-modulated.

**7.** The receiver circuit as defined in any one of claims 1 to 6,
the attenuator including:

an attenuation capacitor provided between an input node of the received signal and an output node of the attenuator; and
an attenuation transistor provided between the output node and a first power supply, a control voltage from the control circuit being input to a gate of the attenuation transistor.

**8.** An amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and
a gain setting section that sets a gain of the amplifier circuit,
when a first bias current that flows through the first operational amplifier is referred to as IB1 and a second bias current that flows through the second operational amplifier is referred to as IB2, the amplifier circuit being provided with frequency characteristics of a band-pass filter by setting the first bias current IB1 to be larger than the second bias current IB2.

**9.** The amplifier circuit as defined in claim 8,
a low-frequency-side cut-off frequency of the band-pass filter being set based on an output impedance of the second operational amplifier and a load capacitance of an output node of the second operational amplifier, and a high-frequency-side cut-off frequency of the band-pass filter being set based on an output impedance of the first operational amplifier and a load capacitance of an output node of the first operational amplifier.

**10.** The amplifier circuit as defined in claim 8 or 9,
the gain setting section including:

a first capacitor provided between an output of the first operational amplifier and the second input terminal of the first operational amplifier; and
a second capacitor provided between an output of the second operational amplifier and a first power supply.

**11.** The amplifier circuit as defined in any one of claims 8 to 10,
when an offset voltage of the first operational amplifier is referred to as VOF1 and an offset voltage of the second operational amplifier is referred to as VOF2, the offset voltage VOF1 being set to be higher than the offset voltage VOF2.

**12.** The amplifier circuit as defined in claim 11,
when a gate length and a gate width of differential-pair transistors of the first operational amplifier are respectively referred to as L1 and W1 and a gate length and a gate width of differential-pair transistors of the second operational amplifier are respectively referred to as L2 and W2, L1×W1 being set to be smaller than L2×W2.

**13.** An amplifier circuit comprising:

a first operational amplifier, an input signal being input to a first input terminal of the first operational amplifier;
a second operational amplifier that is a voltage-follower-connected operational amplifier, an output from the first operational amplifier being input to a first input terminal of the second operational amplifier, and an output from the second operational amplifier being input to a second input terminal of the second operational amplifier and a second input terminal of the first operational amplifier; and

a gain setting section that sets a gain of the amplifier circuit,
the second operational amplifier being a rail-to-rail operational amplifier.

14. The amplifier circuit as defined in claim 13,
the second operational amplifier including:

a first differential section that includes a first current-mirror circuit, first differential-pair transistors, and a first current source transistor;
a second differential section that includes a second current-mirror circuit, second differential-pair transistors, and a second current source transistor;
an output section, an output from the first differential section being input to the output section;
a first transistor provided between a first node and a first power supply, the first node being a drain node of one transistor of the first differential-pair transistors of the first differential section, and a third node being connected to a gate of the first transistor, the third node being a drain node of one transistor of the second differential-pair transistors of the second differential section; and
a second transistor provided between a second node and the first power supply, the second node being a drain node of the other transistor of the first differential-pair transistors, and a fourth node being connected to a gate of the second transistor, the fourth node being a drain node of the other transistor of the second differential-pair transistors;
a gate of the one transistor of the first differential-pair transistors being connected to a gate of the other transistor of the second differential-pair transistors; and
a gate of the other transistor of the first differential-pair transistors being connected to a gate of the one transistor of the second differential-pair transistors.

15. The amplifier circuit as defined in any one of claims 8 to 13,
the first operational amplifier including a differential section;
the second operational amplifier including a first differential section and a second differential section;
an output of the differential section of the first operational amplifier being connected to first input terminals of the first differential section and the second differential section of the second operational amplifier; and
an output of the first differential section being connected to an output of the second differential section, and the output of the first differential section and the output of the second differential section being connected to a second input terminal of the first differential section and a second input terminal of the second differential section.

16. The amplifier circuit as defined in claim 15,
the differential section of the first operational amplifier including:

a current-mirror circuit;
differential-pair transistors, the input signal being input to a gate of one transistor of the differential-pair transistors, and the output of the first differential section and the output of the second differential section being connected to a gate of the other transistor of the differential-pair transistors; and
a current source transistor that supplies a bias current that flows through the current-mirror circuit and the differential-pair transistors;
the first differential section of the second operational amplifier including:
a first current-mirror circuit that is configured by P-type transistors;
first differential-pair transistors, an output of the differential section being connected to a gate of one N-type transistor of the first differential-pair transistors, and the output of the first differential section and the output of the second differential section being connected to a gate of the other N-type transistor of the first differential-pair transistors; and
a first current source transistor that supplies a bias current that flows through the first current-mirror circuit and the first differential-pair transistors and is configured by an N-type transistor; and
the second differential section of the second operational amplifier including:
a second current-mirror circuit that is configured by N-type transistors;
second differential-pair transistors, the output of the differential section being connected to a gate of one P-type transistor of the second differential-pair transistors, and the output of the first differential section and the output of the second differential section being connected to a gate of the other P-type transistor of the second differential-pair transistors; and
a second current source transistor that supplies a bias current that flows through the second current-mirror circuit and the second differential-pair transistors and is configured by a P-type transistor.

17. The amplifier circuit as defined in claim 16,
the differential-pair transistors of the differential section, the first differential-pair transistors of the first differential section, and the second current-mirror circuit of the second differential section being disposed along a first direction; and
when a direction perpendicular to the first direction is referred to as a second direction, the second differential-pair transistors of the second differential section being disposed in the second direction with respect to the second current-mirror circuit.

18. The amplifier circuit as defined in claim 17,
an output line of the differential section being provided along the first direction from the differential-pair transistors toward the second current-mirror circuit, and provided along the second direction from the second current-mirror circuit toward the second differential-pair transistors.

19. The amplifier circuit as defined in claim 18,
the gain setting section including:

a first capacitor provided between the output of the first operational amplifier and the second input terminal of the first operational amplifier; and
a second capacitor provided between the output of the second operational amplifier and a first power supply;
when a direction opposite to the first direction is referred to as a third direction and a direction opposite to the second direction is referred to as a fourth direction, the output line of the differential section being provided along the third direction from the second differential-pair transistors toward the first capacitor and connected to one end of the first capacitor; and
a connection line from the other end of the first capacitor being provided along the fourth direction from the first capacitor toward the differential-pair transistors of the differential section.

20. The amplifier circuit as defined in any one of claims 17 to 19,
when a direction opposite to the second direction is referred to as a fourth direction, the current source transistor of the differential section being disposed in the fourth direction with respect to the differential-pair transistors, and
the first current source transistor of the first differential section being disposed in the fourth direction with respect to the first differential-pair transistors.

# FIG. 1

EP 1 990 913 A2

# FIG. 2

# FIG. 3

EP 1 990 913 A2

FIG. 4

# FIG. 5

VS6

**92**

REFERENCE
VOLTAGE
GENERATION
CIRCUIT

VREF1

VREF2

CPF1

VS11

**94**

CLK

CHARGE
-PUMP
CIRCUIT

Q

VS12

CPF2

VS13

# FIG. 6

VS6

VS11

VS12

VS13

D1

D2

D3

VREF1

VREF2

EP 1 990 913 A2

# FIG. 7

# FIG. 8

# FIG. 9

FIG. 10

FIG. 11

# FIG. 12

# FIG. 13

106
(OUTPUT SECTION)

104
SECOND
(DIFFERENTIAL SECTION)

102
FIRST
(DIFFERENTIAL SECTION)

# FIG. 14

# FIG. 15

EP 1 990 913 A2

# FIG. 16

VS2

NA2

OPC1

VS3

VOF1
(L1 × W1)

VS4

NA4

63

GAIN
SETTING
SECTION

NA3

CC1

OPC2

VOF2
(L2 × W2)

VOF1>VOF2
(L1 × W1<L2 × W2)

CC2

61

# FIG. 17

# FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006037493 A